(19) Europäisches Patentamt
European Patent Office
Office européen des brevets

(11) **EP 4 219 177 B1**

(12) **EUROPEAN PATENT SPECIFICATION**

(45) Date of publication and mention
of the grant of the patent:
**01.10.2025   Bulletin 2025/40**

(21) Application number: **21872083.7**

(22) Date of filing: **26.08.2021**

(51) International Patent Classification (IPC):
*H10F 19/80* (2025.01)          *H01G 9/20* (2006.01)

(52) Cooperative Patent Classification (CPC):
**H01G 9/2077; H10F 19/80;** H01G 9/2009;
H01G 9/2031

(86) International application number:
**PCT/JP2021/031404**

(87) International publication number:
**WO 2022/064951 (31.03.2022 Gazette 2022/13)**

(54) **SOLAR BATTERY MODULE, PANEL, AND PRINTING DATA GENERATION DEVICE**

SOLARBATTERIEMODUL, TAFEL UND DRUCKDATENERZEUGUNGSVORRICHTUNG

MODULE DE BATTERIE SOLAIRE, PANNEAU ET DISPOSITIF DE GÉNÉRATION DE DONNÉES D'IMPRESSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **25.09.2020   JP 2020161419**

(43) Date of publication of application:
**02.08.2023   Bulletin 2023/31**

(73) Proprietor: **Zeon Corporation
Tokyo 100-8246 (JP)**

(72) Inventor: **YOSHIDA, Masayoshi
Tokyo 100-8246 (JP)**

(74) Representative: **Maiwald GmbH
Elisenhof
Elisenstraße 3
80335 München (DE)**

(56) References cited:
**WO-A1-2017/141100          DE-A1- 10 349 269
JP-A- 2006 086 077          JP-A- 2013 235 938
JP-A- 2014 013 716          JP-A- 2017 216 766
US-A1- 2016 218 234**

**Description**

TECHNICAL FIELD

The present disclosure relates to a solar cell module, a panel, and a printing data generation device.

BACKGROUND

There are known solar cell modules in which printing is performed further toward a light-receiving surface side than a body of the solar cell module (for example, refer to Patent Literature (PTL) 1 and 2).

CITATION LIST

Patent Literature

PTL 1: JP2017-216766A; PTL 2: WO 2017/141100 A1

SUMMARY

(Technical Problem)

It is desirable for a solar cell module such as described above to have excellent design properties and power generation performance.
A first object of the present disclosure is to provide a solar cell module having excellent design properties and power generation performance.
Moreover, a second object of the present disclosure is to provide a solar cell module that is suitable for use with a solar cell module corresponding to the first object.
Furthermore, a third object of the present disclosure is to provide a panel that includes a solar cell module corresponding to the first object or the second object and that has excellent design properties.
Also, a fourth object of the present disclosure is to provide a printing data generation device that is suitable for producing a solar cell module corresponding to the first object or the second object or a panel corresponding to the third object.

(Solution to Problem)

A solar cell module that is a first aspect of the present disclosure corresponding to the first object of the present disclosure comprises: a solar cell module body; and a print layer formed further toward a light-receiving surface side than the solar cell module body by printing with a specific transparency in a specific region, wherein a rear surface side is visible from the light-receiving surface side in at least part of the specific region, and the specific transparency is set such that a condition A, shown below, is satisfied.

[Condition A]

A spectral sensitivity integral ratio A defined by formula (1), shown below, is not less than a specific value A* that the spectral sensitivity integral ratio A takes when printing is performed with a transparency resulting in a short circuit current ratio of 0.6.
[numerical 1]

$$A = \frac{\int_{360}^{830}(f(\lambda))d\lambda}{\int_{360}^{830}(f_{SC}(\lambda))d\lambda} \quad \cdots \quad \text{Formula (1)}$$

$\lambda$: Wavelength (nm)
$f(\lambda)$: Quantum efficiency IPCE (%) in case in which print layer is formed
$f_{SC}(\lambda)$: Quantum efficiency IPCE (%) in case in which print layer is not formed

A configuration such as set forth above makes it possible to obtain excellent design properties with printing at the light-receiving surface side and visibility through to the rear surface side and also to obtain excellent power generation performance with a short circuit current ratio of 0.6 or more even in a case in which whole surface printing is performed in the specific region.

A solar cell module that is a second aspect of the present disclosure corresponding to the first object of the present disclosure comprises: a solar cell module body; and a print layer formed further toward a light-receiving surface side than the solar cell module body by full color, red monochrome, green monochrome, or blue monochrome printing with a specific transparency in a specific region, wherein a rear surface side is visible from the light-receiving surface side in at least part of the specific region, and the specific transparency is set such that a condition B, shown below, is satisfied.

[Condition B]

- A spectral sensitivity integral ratio $A_K$ defined by formula (2), shown below, is 0.50 or more in a case in which the print layer is full color.
- A spectral sensitivity integral ratio $A_R$ defined by formula (3), shown below, is 0.47 or more in a case in which the print layer is red monochrome.
- A spectral sensitivity integral ratio $A_G$ defined by formula (4), shown below, is 0.60 or more in a case in which the print layer is green monochrome.
- A spectral sensitivity integral ratio $A_B$ defined by formula (5), shown below, is 0.63 or more in a case in which the print layer is blue monochrome.

[numerical 2]

$$A_K = \frac{\int_{400}^{700}(f_K(\lambda))d\lambda}{\int_{400}^{700}(f_{SC}(\lambda))d\lambda} \quad \cdots \quad \text{Formula (2)}$$

[numerical 3]

$$A_R = \frac{\int_{400}^{700}(f_R(\lambda))d\lambda}{\int_{400}^{700}(f_{SC}(\lambda))d\lambda} \quad \cdots \quad \text{Formula (3)}$$

[numerical 4]

$$A_G = \frac{\int_{400}^{700}(f_G(\lambda))d\lambda}{\int_{400}^{700}(f_{SC}(\lambda))d\lambda} \quad \cdots \quad \text{Formula (4)}$$

[numerical 5]

$$A_B = \frac{\int_{400}^{700}(f_B(\lambda))d\lambda}{\int_{400}^{700}(f_{SC}(\lambda))d\lambda} \quad \cdots \quad \text{Formula (5)}$$

$f_K(\lambda)$: Quantum efficiency IPCE (%) in case in which print layer is formed by black whole surface printing

$f_R(\lambda)$: Quantum efficiency IPCE (%) in case in which print layer is formed by red monochrome whole surface printing
$f_G(\lambda)$: Quantum efficiency IPCE (%) in case in which print layer is formed by green monochrome whole surface printing
$f_B(\lambda)$: Quantum efficiency IPCE (%) in case in which print layer is formed by blue monochrome whole surface printing

A configuration such as set forth above makes it possible to obtain excellent design properties with full color, red monochrome, green monochrome, or blue monochrome printing at the light-receiving surface side and visibility through to the rear surface side and also to obtain excellent power generation performance with a short circuit current ratio of 0.6 or more even in a case in which whole surface printing is performed in the specific region.

A solar cell module that is a third aspect of the present disclosure corresponding to the first object of the present disclosure comprises: a solar cell module body; and a print layer formed further toward a light-receiving surface side than the solar cell module body by red monochrome, green monochrome, or blue monochrome printing with a specific transparency in a specific region, wherein a rear surface side is visible from the light-receiving surface side in at least part of the specific region, and the specific transparency is set such that a condition C, shown below, is satisfied.

[Condition C]

- A red designated wavelength spectral sensitivity integral ratio $B_R$ defined by formula (6), shown below, is 0.18 or more, a red non-designated wavelength spectral sensitivity integral ratio $C_R$ defined by formula (7), shown below, is 0.29 or more, and a red spectral sensitivity peak ratio $P_R$ defined by formula (8), shown below, is 0.70 or more in a case in which the print layer is red monochrome.
- A green designated wavelength spectral sensitivity integral ratio $B_G$ defined by formula (9), shown below, is 0.37 or more, a green non-designated wavelength spectral sensitivity integral ratio $C_G$ defined by formula (10), shown below, is 0.23 or more, and a green spectral sensitivity peak ratio $P_G$ defined by formula (11), shown below, is 0.78 or more in a case in which the print layer is green monochrome.
- A blue designated wavelength spectral sensitivity integral ratio $B_B$ defined by formula (12), shown below, is 0.38 or more, a blue non-designated wavelength spectral sensitivity integral ratio $C_B$ defined by formula (13), shown below, is 0.25 or more, and a blue spectral sensitivity peak ratio $P_B$ defined by formula (14), shown below, is 0.77 or more in a case in which the print layer is blue monochrome.

[numerical 6]

$$B_R = \frac{\int_{560}^{660}(f_R(\lambda))d\lambda}{\int_{400}^{700}(f_{SC}(\lambda))d\lambda} \quad \cdot \cdot \cdot \text{ Formula (6)}$$

[numerical 7]

$$C_R = \frac{\int_{400}^{560}(f_R(\lambda))d\lambda}{\int_{400}^{700}(f_{SC}(\lambda))d\lambda} + \frac{\int_{660}^{700}(f_R(\lambda))d\lambda}{\int_{400}^{700}(f_{SC}(\lambda))d\lambda} \quad \cdot \cdot \cdot \text{ Formula (7)}$$

[numerical 8]

$$P_R = \frac{f_R(\lambda_{RP})}{f_{SC}(\lambda_{RP})} \quad \cdot \cdot \cdot \text{ Formula (8)}$$

[numerical 9]

$$B_G = \frac{\int_{480}^{580}(f_G(\lambda))d\lambda}{\int_{400}^{700}(f_{SC}(\lambda))d\lambda} \quad \cdot\cdot\cdot \quad \text{Formula (9)}$$

[numerical 10]

$$C_G = \frac{\int_{400}^{480}(f_G(\lambda))d\lambda}{\int_{400}^{700}(f_{SC}(\lambda))d\lambda} + \frac{\int_{580}^{700}(f_G(\lambda))d\lambda}{\int_{400}^{700}(f_{SC}(\lambda))d\lambda} \quad \cdot\cdot\cdot \quad \text{Formula (10)}$$

[numerical 11]

$$P_G = \frac{f_G(\lambda_{GP})}{f_{SC}(\lambda_{GP})} \quad \cdot\cdot\cdot \quad \text{Formula (11)}$$

[numerical 12]

$$B_B = \frac{\int_{430}^{530}(f_B(\lambda))d\lambda}{\int_{400}^{700}(f_{SC}(\lambda))d\lambda} \quad \cdot\cdot\cdot \quad \text{Formula (12)}$$

[numerical 13]

- 6 -

$$C_B = \frac{\int_{400}^{430}(f_B(\lambda))d\lambda}{\int_{400}^{700}(f_{SC}(\lambda))d\lambda} + \frac{\int_{530}^{700}(f_B(\lambda))d\lambda}{\int_{400}^{700}(f_{SC}(\lambda))d\lambda} \quad \cdot\cdot\cdot \quad \text{Formula (13)}$$

[numerical 14]

$$P_B = \frac{f_B(\lambda_{BP})}{f_{SC}(\lambda_{BP})} \quad \cdot\cdot\cdot \quad \text{Formula (14)}$$

$\lambda_{RP}$: $\lambda$ when $f_R(\lambda)$ is at peak in red designated wavelength interval of 560 nm $\leq \lambda \leq$ 660 nm
$\lambda_{GP}$: $\lambda$ when $f_G(\lambda)$ is at peak in green designated wavelength interval of 480 nm $\leq \lambda \leq$ 580 nm
$\lambda_{BP}$: $\lambda$ when $f_B(\lambda)$ is at peak in blue designated wavelength interval of 430 nm $\leq \lambda \leq$ 530 nm

A configuration such as set forth above makes it possible to obtain excellent design properties with red monochrome, green monochrome, or blue monochrome printing at the light-receiving surface side and visibility through to the rear surface side and also to obtain excellent power generation performance with a short circuit current ratio of 0.6 or more even in a case in which whole surface printing is performed in the specific region.

In one embodiment of the present disclosure, the solar cell module body includes a pair of substrates sandwiching at least one power-generating cell, and the print layer is formed on a substrate that is at the light-receiving surface side. A configuration such as set forth above makes it possible to easily provide the print layer further toward the light-receiving surface side than the solar cell module body.

In one embodiment of the present disclosure, the solar cell module body includes a pair of substrates sandwiching at least one power-generating cell, and the print layer is formed on a film that is affixed onto a substrate that is at the light-receiving surface side. A configuration such as set forth above makes it possible to easily provide the print layer further toward the light-receiving surface side than the solar cell module body.

In one embodiment of the present disclosure, an adhesive layer that adheres the film onto the substrate that is at the light-receiving surface side is included, and the adhesive layer is a film-shaped adhesive sheet that has an ultraviolet filter function of blocking ultraviolet light having a wavelength of shorter than 400 nm. A configuration such as set forth above makes it possible to inhibit deterioration of power generation performance of the solar cell module body caused by reception of ultraviolet light through the ultraviolet filter function of the adhesive layer.

In one embodiment of the present disclosure, printing is performed with either or both of a different transparency and a different color from the print layer in a different region from the specific region at a surface where the print layer is formed. A configuration such as set forth above enables enhancement of design properties.

In one embodiment of the present disclosure, the solar cell module body is configured as a dye-sensitized solar cell. A configuration such as set forth above makes it possible to more reliably obtain excellent power generation performance.

A solar cell module that is a fourth aspect of the present disclosure corresponding to the second object of the present disclosure comprises: a solar cell module body; and a print layer formed further toward a rear surface side that is an opposite side to a light-receiving surface side than the solar cell module body by printing with a specific transparency in a specific region, wherein the light-receiving surface side is visible from the rear surface side in at least part of the specific region, and the specific transparency is set such that at least one of the condition A according to claim 1, the condition B according to claim 2, and the condition C according to claim 3 is satisfied in a case in which the print layer is provided at the light-receiving surface side instead of the rear surface side. A configuration such as set forth above makes it possible to obtain excellent design properties suitable for use with a solar cell module corresponding to the first object described above through printing being performed at the rear surface side with the same level of transparency as for the solar cell module corresponding to the first object while also enabling visibility through to the light-receiving surface side.

A panel that is a fifth aspect of the present disclosure corresponding to the third object of the present disclosure comprises: the solar cell module described above; and a sheet having the solar cell module affixed in a partial region, wherein the sheet includes a print layer that is formed in a different region from the partial region and in which printing straddling the print layer of the solar cell module is formed. A configuration such as set forth above makes it possible to obtain excellent design properties because printing can be performed for a large screen that is a combination of the print layer of the solar cell module and the print layer of the sheet.

A printing data generation device that is a fifth aspect of the present disclosure corresponding to the fourth object of the present disclosure is a printing data generation device that generates printing data for printing only one part of a specific image in the solar cell module described above, comprising a data processing section that obtains printing data corresponding to the one part of the specific image from data corresponding to the specific image in order to form the print layer. A configuration such as set forth above makes it possible to easily obtain printing data corresponding to the solar cell module, which makes it possible to easily generate printing data for printing only one part of a specific image in the solar cell module.

A printing data generation device that is a sixth aspect of the present disclosure corresponding to the fourth object of the present disclosure is a printing data generation device that generates printing data for printing a specific image in the panel described above, comprising a data processing section that obtains printing data corresponding to one part of the specific image from data corresponding to the specific image in order to form the print layer of the solar cell module that is to display only the one part of the specific image and that obtains printing data corresponding to another part of the specific image from data corresponding to the specific image in order to form the print layer of the sheet that is to display only the other part of the specific image. A configuration such as set forth above makes it possible to easily obtain printing data corresponding to each of the solar cell module and the sheet, which makes it possible to easily generate printing data for printing a specific image in the panel.

(Advantageous Effect)

According to the present disclosure, it is possible to provide a solar cell module corresponding to the first object.

Moreover, according to the present disclosure, it is possible to provide a solar cell module corresponding to the second object.

Furthermore, according to the present disclosure, it is possible to provide a panel corresponding to the third object.

Also, according to the present disclosure, it is possible to provide a printing data generation device corresponding to the fourth object.

BRIEF DESCRIPTION OF THE DRAWINGS

In the accompanying drawings:

FIG. 1 is an exploded perspective view of a solar cell module according to a first embodiment of the present disclosure;

FIG. 2 is a cross-sectional view of a solar cell module body illustrated in FIG. 1;

FIG. 3 presents micrographs of print layers taken for when whole surface printing of each of red monochrome, green monochrome, blue monochrome, and black was performed with various different transparencies in the solar cell module illustrated in FIG. 1;

FIG. 4 presents micrographs that are enlargements of some of the micrographs in FIG. 3;

FIG. 5A is a graph illustrating normalized IV characteristics measured for when whole surface printing of red monochrome was performed with various different transparencies in the solar cell module illustrated in FIG. 1;

FIG. 5B is a graph illustrating IPCE characteristics measured for when whole surface printing of red monochrome was performed with various different transparencies in the solar cell module illustrated in FIG. 1;

FIG. 6A is a graph illustrating normalized IV characteristics measured for when whole surface printing of green monochrome was performed with various different transparencies in the solar cell module illustrated in FIG. 1;

FIG. 6B is a graph illustrating IPCE characteristics measured for when whole surface printing of green monochrome was performed with various different transparencies in the solar cell module illustrated in FIG. 1;

FIG. 7A is a graph illustrating normalized IV characteristics measured for when whole surface printing of blue monochrome was performed with various different transparencies in the solar cell module illustrated in FIG. 1;

FIG. 7B is a graph illustrating IPCE characteristics measured for when whole surface printing of blue monochrome was performed with various different transparencies in the solar cell module illustrated in FIG. 1;

FIG. 8A is a graph illustrating normalized IV characteristics measured for when whole surface printing of black was performed with various different transparencies in the solar cell module illustrated in FIG. 1;

FIG. 8B is a graph illustrating IPCE characteristics measured for when whole surface printing of black was performed with various different transparencies in the solar cell module illustrated in FIG. 1;

FIG. 9 is a graph illustrating transparency on a horizontal axis and normalized short circuit current on a vertical axis that was prepared based on measurement data illustrated in FIG. 5A, FIG. 6A, FIG. 7A, and FIG. 8A;

FIG. 10 is a graph illustrating transparency on a horizontal axis and spectral sensitivity integral ratio $A_R$, red designated wavelength spectral sensitivity integral ratio $B_R$, and red non-designated wavelength spectral sensitivity integral ratio $C_R$ on a vertical axis that was prepared based on measurement data illustrated in FIG. 5B;

FIG. 11 is a graph illustrating transparency on a horizontal axis and spectral sensitivity integral ratio $A_G$, green designated wavelength spectral sensitivity integral ratio $B_G$, and green non-designated wavelength spectral sensitivity integral ratio $C_G$ on a vertical axis that was prepared based on measurement data illustrated in FIG. 6B;

FIG. 12 is a graph illustrating transparency on a horizontal axis and spectral sensitivity integral ratio $A_B$, blue designated wavelength spectral sensitivity integral ratio $B_B$, and blue non-designated wavelength spectral sensitivity integral ratio $C_B$ on a vertical axis that was prepared based on measurement data illustrated in FIG. 7B;

FIG. 13 is a graph illustrating an IPCE characteristic measured for when whole surface printing of red monochrome was performed with a transparency of 50% and an IPCE characteristic measured for when printing was not performed in the solar cell module illustrated in FIG. 1;

FIG. 14 is a graph illustrating an IPCE characteristic measured for when whole surface printing of green monochrome was performed with a transparency of 50% and an IPCE characteristic measured for when printing was not performed in the solar cell module illustrated in FIG. 1;

FIG. 15 is a graph illustrating an IPCE characteristic measured for when whole surface printing of blue monochrome was performed with a transparency of 50% and an IPCE characteristic measured for when printing was not performed in the solar cell module illustrated in FIG. 1;

FIG. 16 is a graph illustrating an IPCE characteristic measured for when whole surface printing of black with a transparency of 58% and an IPCE characteristic measured for when printing was not performed in the solar cell module illustrated in FIG. 1;

FIG. 17 is a plan view illustrating an outline of printing for a case in which two types of printing are performed in the solar cell module illustrated in FIG. 1;

FIG. 18 is an exploded perspective view of a solar cell module according to a second embodiment of the present disclosure;

FIG. 19 is a plan view illustrating an outline of production of a panel according to one embodiment of the present disclosure; and

FIG. 20 is a block diagram illustrating a printing data generation device according to one embodiment of the present disclosure.

DETAILED DESCRIPTION

The following provides a detailed illustrative description of a solar cell module, a panel, and a printing data generation device according to one embodiment of the present disclosure with reference to the drawings.

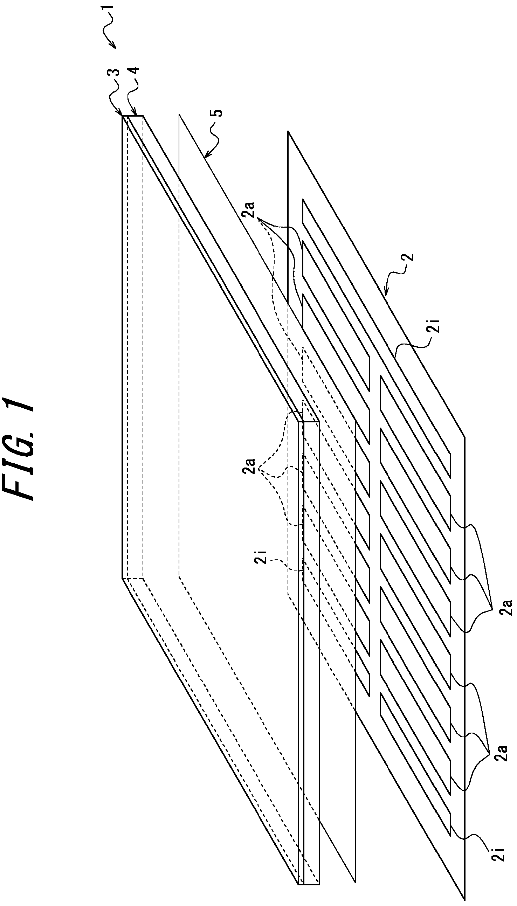

As illustrated in FIG. 1, a solar cell module 1 according to a first embodiment of the present disclosure includes a solar cell module body 2 and a print layer 3 formed further toward a light-receiving surface side than the solar cell module body 2 by printing with a specific transparency T in a specific region. The specific region where the print layer 3 is formed is all regions of the solar cell module body 2 (i.e., the whole light-receiving surface) in the present embodiment.

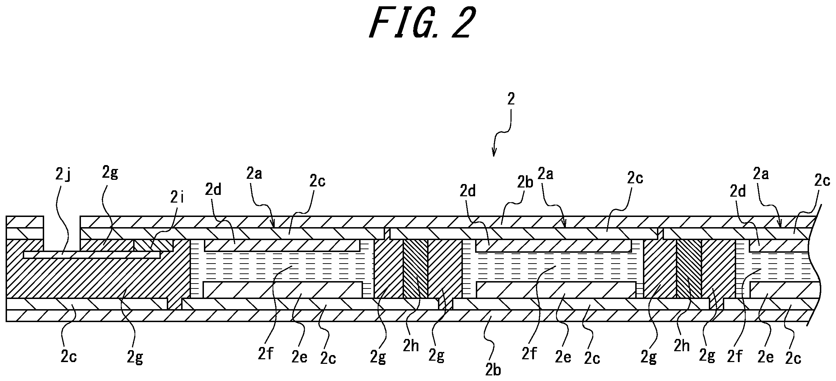

More specifically, the solar cell module body 2 includes a pair of substrates 2b sandwiching a plurality of power-generating cells 2a as illustrated in FIG. 2, and the print layer 3 is formed on a film 4 that is affixed onto a substrate 2b that is at the light-receiving surface side. The number of power-generating cells 2a is 12. However, the number of power-generating cells 2a may be one or more.

The solar cell module 1 also includes an adhesive layer 5 that adheres the film 4 onto the substrate 2b that is at the light-receiving surface side. The adhesive layer 5 is a film-shaped adhesive sheet that has an ultraviolet filter function of blocking ultraviolet light having a wavelength of shorter than 400 nm.

The solar cell module body 2 is configured as dye-sensitized solar cells as illustrated in FIG. 2. In other words, the solar cell module body 2 is configured as a plurality of power-generating cells 2a that are of a dye-sensitized type. Although examples of solar cells (photoelectric conversion elements that convert light energy to electrical power) include silicon solar cells and the like in addition to dye-sensitized solar cells, dye-sensitized solar cells, in particular, benefit from being advantageous in terms of weight reduction, having a wide illumination range in which stable power generation is possible, only requiring small-scale production equipment, being producible with cheap materials, and so forth.

Each of the power-generating cells 2a includes a pair of conductive films 2c formed on inner surfaces of the pair of substrates 2b, a porous semiconductor layer 2d formed on an inner surface of the conductive film 2c that is at the light-receiving surface side, a catalyst layer 2e formed on an inner surface of the conductive film 2c that is at a rear surface side (opposite side to the light-receiving surface side), and a charge transport layer 2f formed between the porous semiconductor layer 2d and the catalyst layer 2e.

The plurality of power-generating cells 2a are isolated from one another through a non-conductive adhesive layer 2g that adheres the pair of substrates 2b to each other and are connected in series through wiring structures 2h formed in the adhesive layer 2g. As illustrated in FIG. 1, current-collecting electrodes 2i are formed at both ends and a middle section of a row of power-generating cells 2a that is formed through series connection of the plurality of power-generating cells 2a. In addition, terminals 2j for extraction of electrical power are formed at both ends of the row of power-generating cells 2a as illustrated in FIG. 2. Note that the arrangement of the current-collecting electrodes 2i and the terminals 2j can be altered as appropriate. Moreover, a configuration in which the current-collecting electrodes 2i and the terminals 2j are not provided may be adopted.

The pair of substrates 2b, the pair of conductive films 2c, the charge transport layer 2f, and the adhesive layer 2g have transparency that allows transmission of visible light.

Each of the substrates 2b may be formed of a resin, glass, metal (titanium, SUS, aluminum, etc.), any combination thereof, or the like, without any specific limitations. Examples of resins that may form the substrates 2b include polyethylene terephthalate (PET), polyethylene naphthalate (PEN), syndiotactic polystyrene (SPS), polyphenylene sulfide (PPS), polycarbonate (PC), polyarylate (PAr), polysulfone (PSF), polyester sulfone (PES), polyetherimide (PEI), cycloolefin polymer (COP), and transparent polyimide (PI), of which, polyethylene terephthalate (PET), polyethylene naphthalate (PEN), and the like are preferable. Note that one of these resins may be used individually, or two or more of these resins may be used in combination.

Each of the conductive films 2c is electrically conductive. The conductive films 2c can each be formed of a metal such as platinum, gold, silver, copper, aluminum, indium, or titanium, a conductive metal oxide such as tin oxide or zinc oxide, a complex metal oxide such as indium tin oxide (ITO), indium zinc oxide (IZO), or fluorine-doped tin (FTO), a carbon material such as carbon nanotubes or graphene, or the like, for example, without any specific limitations. Note that one of these materials may be used individually, or two or more of these materials may be used in combination.

The charge transport layer 2f can receive electrons from the catalyst layer 2e and can thereby replenish electrons of sensitizing dye that is in an oxidized state among sensitizing dye adsorbed to the porous semiconductor layer 2d. The charge transport layer 2f may be formed of a hole transport material such as a polycarbazole, an electron transport material such as tetranitrofluorenone, a conductive polymer such as a polyol, an ion conductor such as a liquid electrolyte or a polymeric electrolyte, a p-type semiconductor such as copper iodide or copper thiocyanate, or the like, for example. One example of a liquid ion conductor is an iodine-based ion conductor that is obtained by dissolving iodine, an alkali salt such as lithium iodide or potassium iodide, and an ionic liquid such as dimethylpropylimidazolium iodide or tetrapropylammonium iodide in a solvent such as propylene carbonate, ethanol, $\gamma$-butyrolactone, acetonitrile, propionitrile, or 3-methoxypropionitrile. Note that one of these materials may be used individually, or two or more of these materials may be used in combination.

The adhesive layer 2g can, for example, be formed of a thermoplastic resin, a thermosetting resin, or an active radiation (light, electron beam) curable resin, and, more specifically, can be formed of acrylic resin, methacrylic resin, fluororesin, silicone resin, olefin resin, polyamide resin, or the like. Note that one of these materials may be used individually, or two or more of these materials may be used in combination. These materials may contain 0.001 volume% to 50 volume% of silica, talc, alumina, titanium oxide, aluminum hydroxide, any combination thereof, or the like, having a median particle diameter of 0.001 $\mu$m to 10 $\mu$m.

The wiring structures 2h included in the adhesive layer 2g can, for example, be formed of particles of a metal such as Ag, Au, Cu, Al, In, Sn, Bi, or Pb or an oxide thereof, particles of conductive carbon, or particles obtained by coating the surfaces of organic compound particles such as resin particles or inorganic compound particles with a conductive substance such as a metal (Ag, Au, Cu, etc.) or oxide thereof. For example, the wiring structures 2h can be formed of particles that are coated with Au/Ni alloy or the like. Note that one of these materials may be used individually, or two or more of these materials may be used in combination. The wiring structures 2h may alternatively be provided separately to the adhesive layer 2g.

The porous semiconductor layer 2d is formed of a semiconductor that is porous in order to enable good adsorption of a sensitizing dye. The porous semiconductor layer 2d is a semiconductor fine particulate layer that is formed of fine particles of an oxide semiconductor such as titanium oxide. However, the porous semiconductor layer 2d may be a semiconductor fine particulate layer formed of fine particles of an oxide semiconductor other than titanium oxide or may be formed of a layer other than a semiconductor fine particulate layer. The semiconductor fine particles for forming the semiconductor fine particulate layer may be fine particles of an oxide semiconductor such as titanium oxide, zinc oxide, or tin oxide, for example. Note that one of these materials may be used individually, or two or more of these materials may be used in combination.

The porous semiconductor layer 2d supports a sensitizing dye. The sensitizing dye may be an organic dye, a metal complex dye, or the like, for example. The organic dye may be an azo dye, a cyanine dye, a merocyanine dye, an oxonol dye, a xanthene dye, a squarylium dye, a polymethine dye, a coumarin dye, a riboflavin dye, a perylene dye, or the like, for example. The metal complex dye may be a phthalocyanine complex dye or a porphyrin complex dye of a metal such as iron, copper, or ruthenium, or may be a ruthenium bipyridine complex dye, or the like, for example. Note that one of the dye materials described above may be used individually, or two or more of the dye materials described above may be used in combination.

The catalyst layer 2e can be formed of a catalyst such as a conductive polymer, a carbon nanostructure, particles or a thin film of a precious metal, or a mixture of a carbon nanostructure and precious metal particles, for example, without any specific limitations. The conductive polymer may be a polythiophene such as poly(thiophene-2,5-diyl), poly(3-butylthiophene-2,5-diyl), poly(3-hexylthiophene-2,5-diyl), or poly(2,3-dihydrothieno-[3,4-b]-1,4-dioxine) (PEDOT), a polyacetylene or derivative thereof, a polyaniline or derivative thereof, a polypyrrole or derivative thereof, a polyphenylene vinylene such as poly(p-xylene tetrahydrothiophenium chloride), poly[(2-methoxy-5-(2'-ethylhexyloxy))-1,4-phenylenevinylene], poly[(2-methoxy-5-(3',7'-dimethyloctyloxy)-1,4-phenylenevinylene)], or poly[2-(2',5'-bis(2"-ethylhexyloxy)phenyl)-1,4-phenylenevinylene], or the like, for example. The carbon nanostructure may be natural graphite, carbon black, acetylene black, Ketjenblack, activated carbon, artificial graphite, graphene, carbon nanotubes, carbon nanobuds, or the like, for example. The precious metal particles may be platinum, palladium, ruthenium, or the like, for example. Note that one of these materials may be used individually, or two or more of these materials may be used in combination. The catalyst layer 2e may also optionally contain a dispersant and/or a binder, etc.

The solar cell module 1 has a configuration in which the rear surface side is visible from the light-receiving surface side in at least part of the specific region where the print layer 3 is formed. Note that the term "visible" as used here means that at least one element among shape, pattern, and color that are elements constituting the form of a background positioned at the opposite side of the solar cell module 1 can be recognized by sight.

A plurality of types of solar cell modules 1 according to the present embodiment that differed in terms of transparency T and color were produced. These solar cell modules 1 were produced by inputting a specific transparency T to a specific general-purpose printer (ApeosPort C3373 L-4G4F-10A produced by Fuji Xerox Co., Ltd.; https://www.fujixerox.co.jp/support/manual/mf/ap7_c7773/manu.html), and then performing each of red monochrome whole surface printing, green monochrome whole surface printing, blue monochrome whole surface printing, and black whole surface printing.

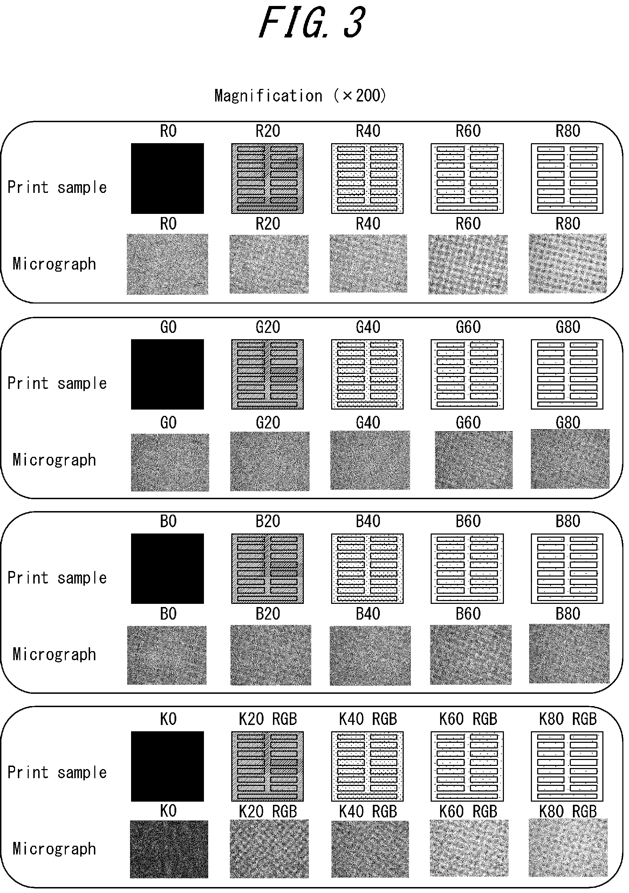

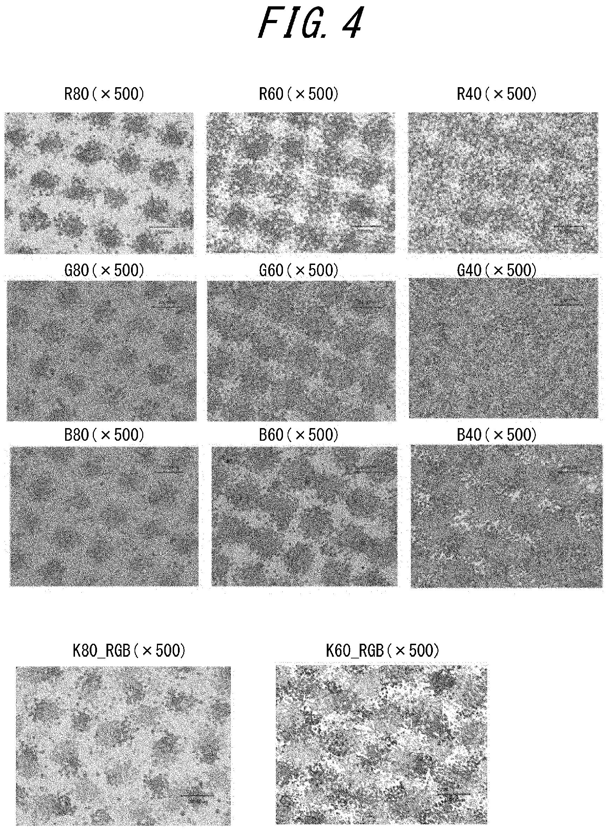

Examples of the produced solar cell modules 1 are illustrated in FIG. 3. In FIG. 3, the external appearance of a solar cell module 1 and a micrograph of a print layer 3 are presented as a set. Some of the micrographs presented in FIG. 3 are presented in an enlarged form in FIG. 4.

Note that in FIGS. 3 and 4, and also in other drawings, R indicates red monochrome whole surface printing, G indicates green monochrome whole surface printing, B indicates blue monochrome whole surface printing, K indicates black whole surface printing, and the number following each of these letters indicates the transparency T as a percentage. For example, R80 indicates red monochrome whole surface printing with a transparency T of 80%. Also note that SC is used to indicate "no printing" in the following description.

In the case of black whole surface printing, the printing was formed using a black pigment for a transparency T of 0% and was formed using a mixture of red, green, and blue (mixture of cyan pigment, magenta pigment, and yellow pigment) for other transparencies T. In the case of red monochrome whole surface printing, the printing was formed using a mixture of a magenta pigment and a yellow pigment. In the case of green monochrome whole surface printing, the printing was formed using a mixture of a yellow pigment and a cyan pigment. In the case of blue monochrome whole surface printing, the printing was formed using a mixture of a cyan pigment and a magenta pigment.

The printing was formed by dots arranged equidistantly lengthwise and widthwise in a lattice shape. An aggregate of pigments of the necessary colors was formed at each of these dots. For example, in the case of black formed using a mixture of colors, an aggregate of pigments of the three colors described above was formed at each of the dots. The distance between the dots (distance between dot centers) was approximately 130 $\mu$m both lengthwise and widthwise. The aggregate amount of pigment at each dot was linked to the transparency T such that the aggregate amount increased with decreasing transparency T.

In this manner, printing performed with a specific transparency T using a typical printer (also referred to as transparent printing) is halftone printing with a density in accordance with the transparency T.

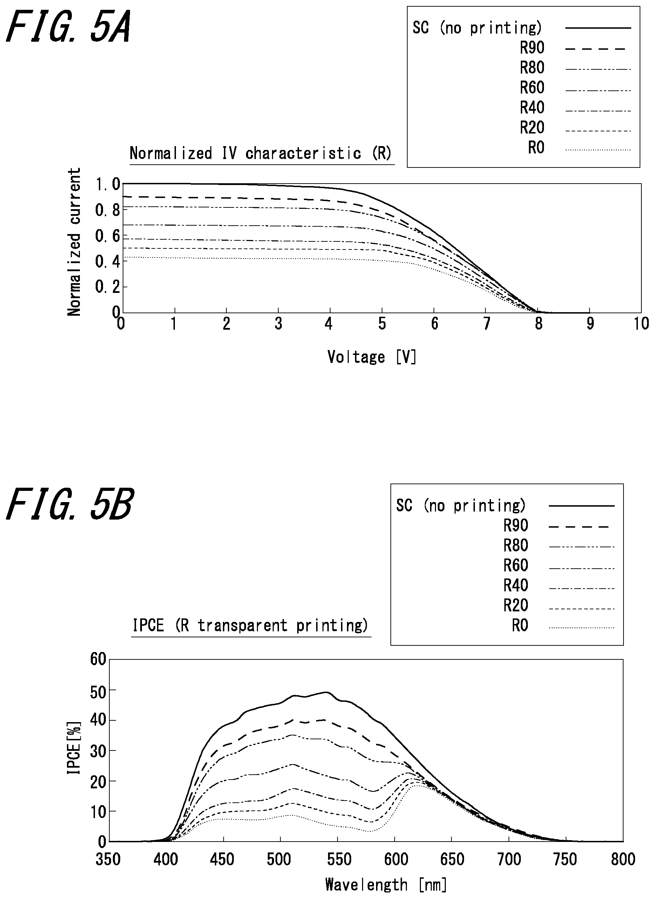

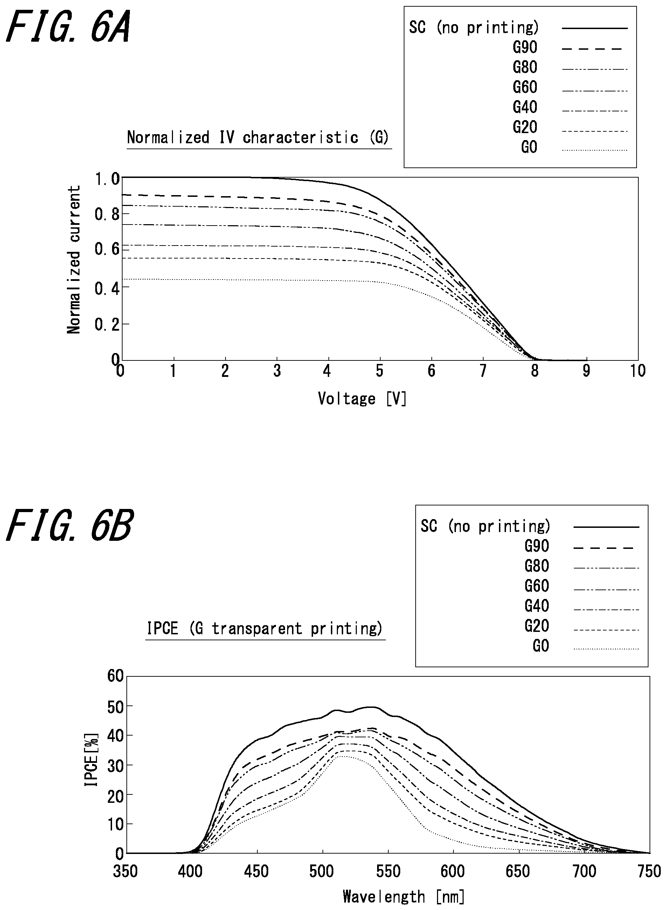

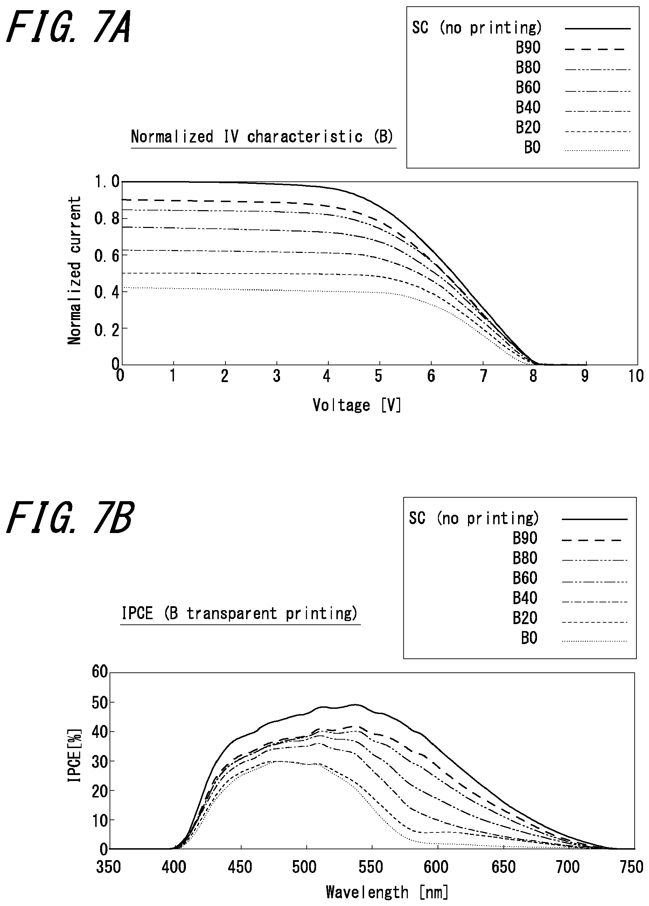

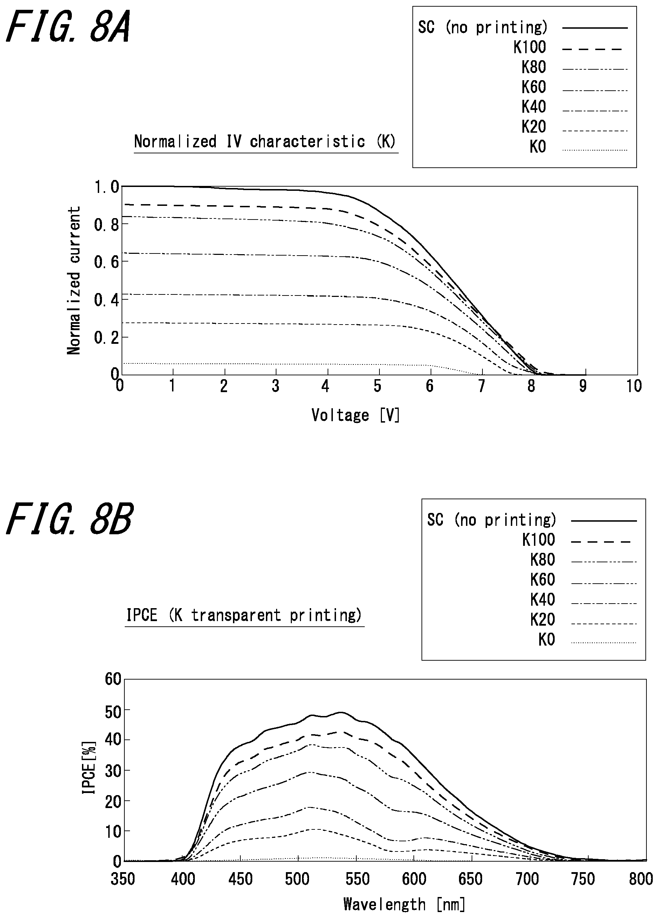

A current/voltage characteristic (IV characteristic) was measured with an irradiation intensity of 1 SUN (100 mW/cm$^2$) for each of the plurality of types of solar cell modules 1 produced as described above. The results are presented in FIG. 5A, FIG. 6A, FIG. 7A, and FIG. 8A as a normalized IV characteristic in which the current value at each transparency T is indicated as a normalized current value that is normalized through division by the current value at a transparency T of 100% (i.e., not printed). Note that FIG. 5A presents results for red printing, FIG. 6A presents results for green printing, FIG. 7A presents results for blue printing, and FIG. 8A presents results for black printing. Measurement of this IV characteristic was performed using a solar simulator "PEC-L15" produced by Peccell Technologies Inc. and an IV characteristic measurement device "PECK2400-N" produced by Peccell Technologies Inc.

In addition, an IPCE characteristic (IPCE: quantum efficiency, Incident Photon to Current conversion Efficiency) was measured for each of the plurality of types of solar cell modules 1 produced as described above. The results are presented in FIG. 5B, FIG. 6B, FIG. 7B, and FIG. 8B. Note that FIG. 5B presents results for red printing, FIG. 6B presents results for green printing, FIG. 7B presents results for blue printing, and FIG. 8B presents results for black printing. Measurement of this IPCE characteristic was performed using a solar cell spectral sensitivity measurement system that was constructed using control software "W32-B2900SOLAS" produced by Systemhouse Sunrise Corp., a measurement device "B2901A" produced by Keysight Technologies, and a monochromatic light source "MLS-1510" produced by Asahi Spectra Co., Ltd.

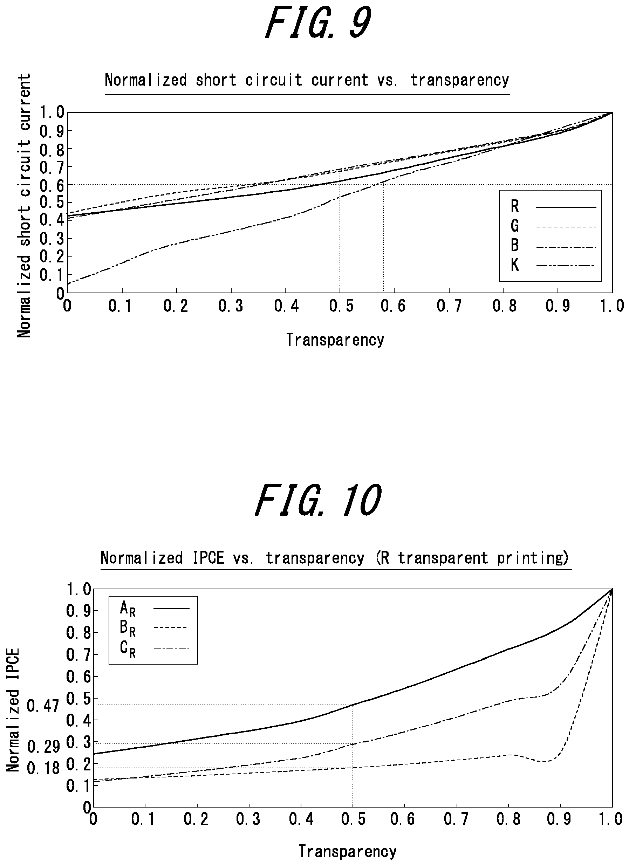

Relationships between transparency T and normalized short circuit current that were calculated from IV characteristics measured as described above are illustrated in FIG. 9. It can be seen from relationships illustrated in FIG. 9 that the normalized short circuit current (i.e., a short circuit current ratio) is 0.6 or more when the transparency T is 0.5 or more for each of red monochrome whole surface printing, green monochrome whole surface printing, and blue monochrome whole surface printing. Moreover, it can be seen from a relationship illustrated in FIG. 9 that the short circuit current ratio is 0.6 or more when the transparency T is 0.58 or more in the case of black whole surface printing.

The following relationship is generally known to exist between short circuit current density and IPCE.

[numerical 15]

$$ J_{SC} = \int \frac{P_{in\lambda} \times \lambda}{1.99 \times 10^{-16}} \times \frac{IPCE_\lambda}{100} \times \frac{1}{6.24 \times 10^{18}} d\lambda \quad \cdots \quad \text{Formula (15)} $$

$J_{SC}$: Short circuit current density (mA/cm$^2$) with no printing
$\lambda$: Wavelength (nm)
$P_{in\lambda}$: Incident light intensity (mW/cm$^2$)

Accordingly, the short circuit current ratio I for red monochrome whole surface printing, green monochrome whole surface printing, blue monochrome whole surface printing, and black whole surface printing can theoretically be represented by the following formulae based on relationships $I_R = J_R/J_{SC}$, $I_G = J_G/J_{SC}$, $I_B = J_B/J_{SC}$, and $I_K = J_K/J_{SC}$. Note that $J_R$ is the short circuit current density for red monochrome whole surface printing, $J_G$ is the short circuit current density for green monochrome whole surface printing, $J_B$ is the short circuit current density for blue monochrome whole surface printing, and $J_K$ is the short circuit current density for black whole surface printing.

[numerical 16]

$$I_R = \frac{\int f_R(\lambda)d\lambda}{\int f_{SC}(\lambda)d\lambda} \quad \cdots \quad \text{Formula (16)}$$

[numerical 17]

$$I_G = \frac{\int f_G(\lambda)d\lambda}{\int f_{SC}(\lambda)d\lambda} \quad \cdots \quad \text{Formula (17)}$$

[numerical 18]

$$I_B = \frac{\int f_B(\lambda)d\lambda}{\int f_{SC}(\lambda)d\lambda} \quad \cdots \quad \text{Formula (18)}$$

[numerical 19]

$$I_K = \frac{\int f_K(\lambda)d\lambda}{\int f_{SC}(\lambda)d\lambda} \quad \cdots \quad \text{Formula (19)}$$

$I_R$: Theoretical short circuit current ratio in case in which print layer is formed by red monochrome whole surface printing

$I_G$: Theoretical short circuit current ratio in case in which print layer is formed by green monochrome whole surface printing

$I_B$: Theoretical short circuit current ratio in case in which print layer is formed by blue monochrome whole surface printing

$I_K$: Theoretical short circuit current ratio in case in which print layer is formed by black whole surface printing

$f_R(\lambda)$: Quantum efficiency IPCE (%) in case in which print layer is formed by red monochrome whole surface printing

$f_G(\lambda)$: Quantum efficiency IPCE (%) in case in which print layer is formed by green monochrome whole surface printing

$f_B(\lambda)$: Quantum efficiency IPCE (%) in case in which print layer is formed by blue monochrome whole surface printing

$f_K(\lambda)$: Quantum efficiency IPCE (%) in case in which print layer is formed by black whole surface printing

A spectral sensitivity integral ratio A that is limited to 400 nm to 700 nm, which is a wavelength region in which stable power generation is possible in a dye-sensitized solar cell, is defined as follows.

[numerical 20]

$$A_R = \frac{\int_{400}^{700}(f_R(\lambda))d\lambda}{\int_{400}^{700}(f_{SC}(\lambda))d\lambda} \quad \cdots \quad \text{Formula (3)}$$

[numerical 21]

$$A_G = \frac{\int_{400}^{700}(f_G(\lambda))d\lambda}{\int_{400}^{700}(f_{SC}(\lambda))d\lambda} \quad \cdots \quad \text{Formula (4)}$$

[numerical 22]

$$A_B = \frac{\int_{400}^{700}(f_B(\lambda))d\lambda}{\int_{400}^{700}(f_{SC}(\lambda))d\lambda} \quad \cdots \quad \text{Formula (5)}$$

[numerical 23]

$$A_K = \frac{\int_{400}^{700}(f_K(\lambda))d\lambda}{\int_{400}^{700}(f_{SC}(\lambda))d\lambda} \quad \cdots \quad \text{Formula (2)}$$

$A_R$: Spectral sensitivity integral ratio for red monochrome whole surface printing
$A_G$: Spectral sensitivity integral ratio for green monochrome whole surface printing
$A_B$: Spectral sensitivity integral ratio for blue monochrome whole surface printing
$A_K$: Spectral sensitivity integral ratio for black whole surface printing

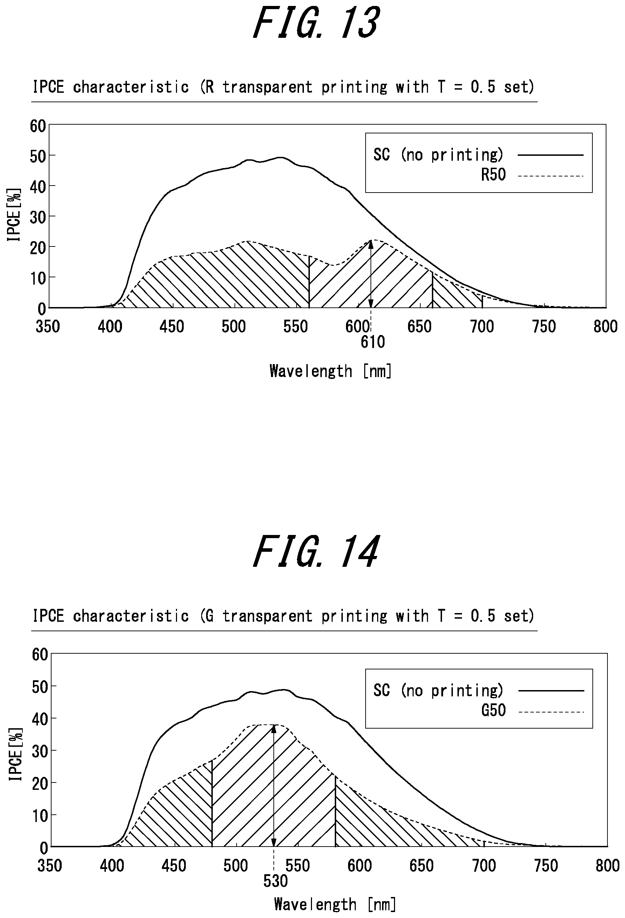

$A_{R50}$, which is the spectral sensitivity integral ratio $A_R$ at a transparency T of 50% that enables the achievement of a short circuit current ratio of 0.6 or more in red monochrome whole surface printing as previously described, corresponds to a normalized value obtained by dividing the area of a hatched section illustrated in FIG. 13 by the area for when there is no printing. This value was calculated to be 0.47.

$A_{G50}$, which is the spectral sensitivity integral ratio $A_G$ at a transparency T of 50% that enables the achievement of a short circuit current ratio of 0.6 or more in green monochrome whole surface printing as previously described, corresponds to a normalized value obtained by dividing the area of a hatched section illustrated in FIG. 14 by the area for when there is no printing. This value was calculated to be 0.60.

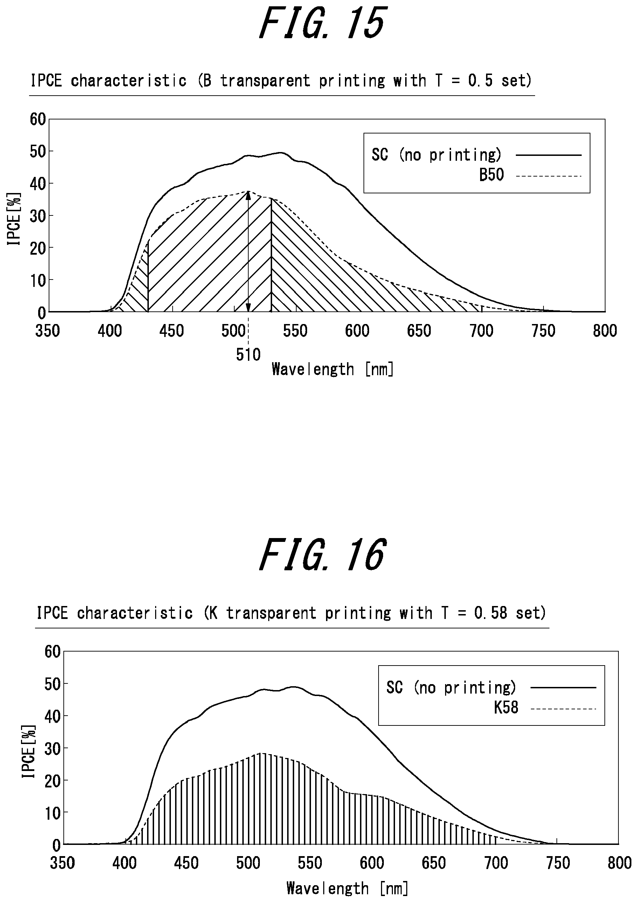

$A_{B50}$, which is the spectral sensitivity integral ratio $A_B$ at a transparency T of 50% that enables the achievement of a short circuit current ratio of 0.6 or more in blue monochrome whole surface printing as previously described, corresponds to a normalized value obtained by dividing the area of a hatched section illustrated in FIG. 15 by the area for when there is no printing. This value was calculated to be 0.63.

$A_{K58}$, which is the spectral sensitivity integral ratio $A_K$ at a transparency T of 58% that enables the achievement of a short circuit current ratio of 0.6 or more in black whole surface printing as previously described, corresponds to a normalized value obtained by dividing the area of a hatched section illustrated in FIG. 16 by the area for when there is no printing. This value was calculated to be 0.50.

Accordingly, in a case in which the print layer 3 is formed further toward the light-receiving surface side than the solar cell module body 2 by full color, red monochrome, green monochrome, or blue monochrome printing with a specific transparency T in a specific region, it is possible to achieve a short circuit current ratio of 0.6 or more by setting the specific transparency T such that the following condition B is satisfied.

[Condition B]

- The spectral sensitivity integral ratio $A_K$ defined by formula (2), shown above, is 0.50 or more in a case in which the print layer 3 is full color.
- The spectral sensitivity integral ratio $A_R$ defined by formula (3), shown above, is 0.47 or more in a case in which the print layer 3 is red monochrome.

- The spectral sensitivity integral ratio $A_G$ defined by formula (4), shown above, is 0.60 or more in a case in which the print layer 3 is green monochrome.
- The spectral sensitivity integral ratio $A_B$ defined by formula (5), shown above, is 0.63 or more in a case in which the print layer 3 is blue monochrome.

A designated wavelength interval is defined for each color among RGB as follows.

Red designated wavelength interval: 610 ± 50 nm
Green designated wavelength interval: 530 ± 50 nm
Blue designated wavelength interval: 480 ± 50 nm

Moreover, a red designated wavelength spectral sensitivity integral ratio $B_R$, a red non-designated wavelength spectral sensitivity integral ratio $C_R$, a red spectral sensitivity peak ratio $P_R$, a green designated wavelength spectral sensitivity integral ratio $B_G$, a green non-designated wavelength spectral sensitivity integral ratio $C_G$, a green spectral sensitivity peak ratio $P_G$, a blue designated wavelength spectral sensitivity integral ratio $B_B$, a blue non-designated wavelength spectral sensitivity integral ratio $C_B$, and a blue spectral sensitivity peak ratio $P_B$ are defined as follows.
[numerical 24]

$$B_R = \frac{\int_{560}^{660}(f_R(\lambda))d\lambda}{\int_{400}^{700}(f_{SC}(\lambda))d\lambda} \quad \cdots \quad \text{Formula (6)}$$

[numerical 25]

$$C_R = \frac{\int_{400}^{560}(f_R(\lambda))d\lambda}{\int_{400}^{700}(f_{SC}(\lambda))d\lambda} + \frac{\int_{660}^{700}(f_R(\lambda))d\lambda}{\int_{400}^{700}(f_{SC}(\lambda))d\lambda} \quad \cdots \quad \text{Formula (7)}$$

[numerical 26]

$$P_R = \frac{f_R(\lambda_{RP})}{f_{SC}(\lambda_{RP})} \quad \cdots \quad \text{Formula (8)}$$

[numerical 27]

$$B_G = \frac{\int_{480}^{580}(f_G(\lambda))d\lambda}{\int_{400}^{700}(f_{SC}(\lambda))d\lambda} \quad \cdots \quad \text{Formula (9)}$$

[numerical 28]

$$C_G = \frac{\int_{400}^{480}(f_G(\lambda))d\lambda}{\int_{400}^{700}(f_{SC}(\lambda))d\lambda} + \frac{\int_{580}^{700}(f_G(\lambda))d\lambda}{\int_{400}^{700}(f_{SC}(\lambda))d\lambda} \quad \cdots \quad \text{Formula (10)}$$

[numerical 29]

$$P_G = \frac{f_G(\lambda_{GP})}{f_{SC}(\lambda_{GP})} \quad \cdots \quad \text{Formula (11)}$$

[numerical 30]

$$B_B = \frac{\int_{430}^{530}(f_B(\lambda))d\lambda}{\int_{400}^{700}(f_{SC}(\lambda))d\lambda} \quad \cdots \quad \text{Formula (12)}$$

[numerical 31]

$$C_B = \frac{\int_{400}^{430}(f_B(\lambda))d\lambda}{\int_{400}^{700}(f_{SC}(\lambda))d\lambda} + \frac{\int_{530}^{700}(f_B(\lambda))d\lambda}{\int_{400}^{700}(f_{SC}(\lambda))d\lambda} \quad \cdots \quad \text{Formula (13)}$$

[numerical 32]

$$P_B = \frac{f_B(\lambda_{BP})}{f_{SC}(\lambda_{BP})} \quad \cdots \quad \text{Formula (14)}$$

$\lambda_{RP}$: $\lambda$ when $f_R(\lambda)$ is at peak in red designated wavelength interval of 560 nm $\leq \lambda \leq$ 660 nm
$\lambda_{GP}$: $\lambda$ when $f_G(\lambda)$ is at peak in green designated wavelength interval of 480 nm $\leq \lambda \leq$ 580 nm
$\lambda_{BP}$: $\lambda$ when $f_B(\lambda)$ is at peak in blue designated wavelength interval of 430 nm $\leq \lambda \leq$ 530 nm

Upon calculation using data illustrated in FIG. 13, which is data for a transparency T of 50% that enables the achievement of a short circuit current ratio of 0.6 in red monochrome whole surface printing as previously described, the red designated wavelength spectral sensitivity integral ratio $B_{R50}$ was 0.18, the red non-designated wavelength spectral sensitivity integral ratio $C_{R50}$ was 0.29, and the red spectral sensitivity peak ratio $P_{R50}$ was 0.70. Note that the position at which $f_R(\lambda)$ is at a peak in the red designated wavelength interval is indicated by a bidirectional arrow in FIG. 13.

Upon calculation using data illustrated in FIG. 14, which is data for a transparency T of 50% that enables the achievement of a short circuit current ratio of 0.6 in green monochrome whole surface printing as previously described, the green designated wavelength spectral sensitivity integral ratio $B_{G50}$ was 0.37, the green non-designated wavelength spectral sensitivity integral ratio $C_{G50}$ was 0.23, and the green spectral sensitivity peak ratio $P_{G50}$ was 0.78. Note that the position at which $f_G(\lambda)$ is at a peak in the green designated wavelength interval is indicated by a bidirectional arrow in FIG. 14.

Upon calculation using data illustrated in FIG. 15, which is data for a transparency T of 50% that enables the achievement of a short circuit current ratio of 0.6 in blue monochrome whole surface printing as previously described, the blue designated wavelength spectral sensitivity integral ratio $B_{B50}$ was 0.38, the blue non-designated wavelength spectral sensitivity integral ratio $C_{B50}$ was 0.25, and the blue spectral sensitivity peak ratio $P_{B50}$ was 0.77. Note that the position at which $f_B(\lambda)$ is at a peak in the blue designated wavelength interval is indicated by a bidirectional arrow in FIG. 15.

Accordingly, in a case in which the print layer 3 is formed further toward the light-receiving surface side than the solar cell module body 2 by red monochrome, green monochrome, or blue monochrome printing with a specific transparency T in a specific region, it is possible to achieve a short circuit current ratio of 0.6 or more by setting the specific transparency T such that the following condition C is satisfied.

[Condition C]

- The red designated wavelength spectral sensitivity integral ratio $B_R$ defined by formula (6), shown above, is 0.18 or more, the red non-designated wavelength spectral sensitivity integral ratio $C_R$ defined by formula (7), shown above, is 0.29 or more, and the red spectral sensitivity peak ratio $P_R$ defined by formula (8), shown above, is 0.70 or more in a case in which the print layer 3 is red monochrome.
- The green designated wavelength spectral sensitivity integral ratio $B_G$ defined by formula (9), shown above, is 0.37 or more, the green non-designated wavelength spectral sensitivity integral ratio $C_G$ defined by formula (10), shown above, is 0.23 or more, and the green spectral sensitivity peak ratio $P_G$ defined by formula (11), shown above, is 0.78 or more in a case in which the print layer 3 is green monochrome.
- The blue designated wavelength spectral sensitivity integral ratio $B_B$ defined by formula (12), shown above, is 0.38 or more, the blue non-designated wavelength spectral sensitivity integral ratio $C_B$ defined by formula (13), shown above, is 0.25 or more, and the blue spectral sensitivity peak ratio $P_B$ defined by formula (14), shown above, is 0.77 or more in a case in which the print layer 3 is blue monochrome.

Moreover, a condition for obtaining excellent power generation performance with which a short circuit current ratio of 0.6 is possible as previously described may be further generalized as follows. In other words, in a case in which the print layer 3 is formed further toward the light-receiving surface side than the solar cell module body 2 by printing with a specific transparency T in a specific region, it is possible to achieve a short circuit current ratio of 0.6 or more by setting the specific transparency T such that the following condition A is satisfied.

[Condition A]

A spectral sensitivity integral ratio A defined by formula (1), shown below, is not less than a specific value A* that the spectral sensitivity integral ratio A takes when printing is performed with a transparency T resulting in a short circuit current ratio of 0.6.

[numerical 33]

$$ A = \frac{\int_{360}^{830} (f(\lambda))d\lambda}{\int_{360}^{830} (f_{SC}(\lambda))d\lambda} \quad \cdots \quad \text{Formula (1)} $$

f($\lambda$): Quantum efficiency IPCE (%) in case in which print layer is formed

$f_{SC}(\lambda)$: Quantum efficiency IPCE (%) in case in which print layer is not formed

The plurality of types of solar cell modules 1 produced as described above were also evaluated in terms of visibility therethrough. In this evaluation, a sheet printed with red, green, blue, and black patterns was arranged as a background at the rear surface side of the solar cell module 1, and an evaluation was made as to whether the sheet was visually recognizable from the light-receiving surface side of the solar cell module 1. This evaluation was a subjective evaluation through human sight. As a result, visual recognition was found to be possible even at a transparency T of 0% in a solar cell module 1 for each of red monochrome whole surface printing, green monochrome whole surface printing, and blue monochrome whole surface printing. Moreover, although visual recognition was not possible at a transparency T of 0% in a solar cell module 1 for black whole surface printing, visual recognition was possible at a transparency T of 20% or more.

Accordingly, it can be seen from these evaluation results for visibility that it is possible to obtain excellent design properties with which the rear surface side is visible from the light-receiving surface side in at least part of the specific region where the print layer 3 is formed when a transparency T that enables excellent power generation performance with which a short circuit current ratio of 0.6 or more can be achieved (i.e., a transparency T of 50% or more in the case of red monochrome whole surface printing, green monochrome whole surface printing, or blue monochrome whole surface printing and a transparency T of 58% or more in the case of black whole surface printing) is adopted.

Thus, a solar cell module 1 according to the present embodiment having excellent design properties and power generation performance can be produced by forming the print layer 3 with a specific transparency T set such that the previously described condition B is satisfied (i.e., through the inclusion of a step of measuring a spectral sensitivity integral ratio when whole surface printing is performed at a given transparency T and judging whether or not the condition B is satisfied, a step of setting a transparency T at which the condition B is satisfied as the specific transparency T, and a step of forming the print layer 3 with the transparency T that has been set).

Moreover, a solar cell module 1 according to the present embodiment having excellent design properties and power generation performance can be produced by forming the print layer 3 with a specific transparency T set such that the previously described condition C is satisfied (i.e., through the inclusion of a step of measuring a designated spectral sensitivity integral ratio, a non-designated spectral sensitivity integral ratio, and a spectral sensitivity peak ratio for when whole surface printing is performed at a given transparency T and judging whether or not the condition C is satisfied, a step of setting a transparency T at which the condition C is satisfied as the specific transparency T, and a step of forming the print layer 3 with the transparency T that has been set).

Furthermore, a solar cell module 1 according to the present embodiment having excellent design properties and power generation performance can be produced by forming the print layer 3 with a specific transparency T set such that the previously described condition A is satisfied (i.e., through the inclusion of a step of determining a specific value A* that the spectral sensitivity integral ratio A takes when printing is performed with a transparency T resulting in a short circuit current ratio of 0.6, a step of measuring the spectral sensitivity integral ratio A for when whole surface printing is performed at a given transparency T and judging whether or not the condition A is satisfied, a step of setting a transparency T at which the condition A is satisfied as the specific transparency T, and a step of forming the print layer 3 with the transparency T that has been set).

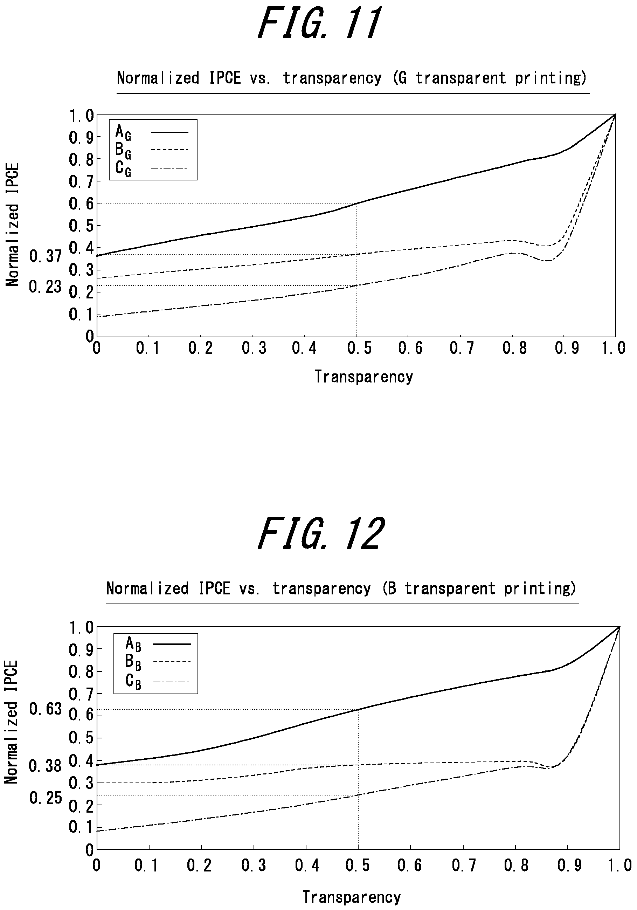

The following describes a relationship between the transparency and the designated wavelength spectral sensitivity integral ratio and non-designated wavelength spectral sensitivity integral ratio for each color among RGB. FIG. 10 illustrates a relationship between the transparency and the red designated wavelength spectral sensitivity integral ratio $B_R$ and red non-designated wavelength spectral sensitivity integral ratio $C_R$. FIG. 11 illustrates a relationship between the transparency and the green designated wavelength spectral sensitivity integral ratio $B_G$ and green non-designated wavelength spectral sensitivity integral ratio $C_G$. FIG. 12 illustrates a relationship between the transparency and the blue designated wavelength spectral sensitivity integral ratio $B_B$ and blue non-designated wavelength spectral sensitivity integral ratio $C_B$.

As illustrated in FIGS. 10 to 12, in a region around where the transparency T is 50%, the non-designated wavelength spectral sensitivity integral ratio is influenced more by a change of the transparency T (i.e., has a larger curve gradient) than the designated wavelength spectral sensitivity integral ratio for each of the colors among RGB. Accordingly, a solar cell module 1 according to the present embodiment having excellent design properties and power generation performance can more easily be produced by forming the print layer 3 with a specific transparency T set such that the following condition D is satisfied (i.e., through the inclusion of a step of measuring a non-designated spectral sensitivity integral ratio for when whole surface printing is performed with a given transparency T and judging whether or not the condition D is satisfied, a step of setting the specific transparency T as a transparency T at which the condition D is satisfied, and a step of forming the print layer 3 with the transparency T that has been set).

[Condition D]

- The red non-designated wavelength spectral sensitivity integral ratio $C_R$ defined by formula (7), shown above, is 0.29 or more in a case in which the print layer is red monochrome.
- The green non-designated wavelength spectral sensitivity integral ratio $C_G$ defined by formula (10), shown above, is 0.23 or more in a case in which the print layer is green monochrome.
- The blue non-designated wavelength spectral sensitivity integral ratio $C_B$ defined by formula (13), shown above, is 0.25 or more in a case in which the print layer is blue monochrome.

In production of the solar cell module 1 according to the present embodiment, production can be facilitated by adopting the condition B as compared to the condition A, by adopting the condition C as compared to the condition B, and by adopting the condition D as compared to the condition C.

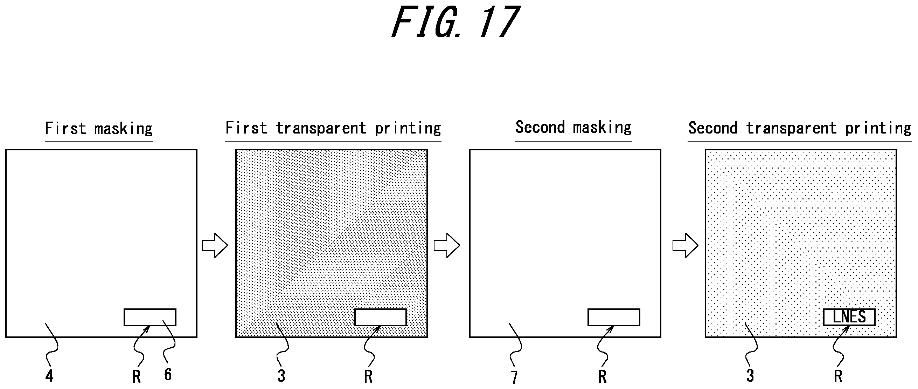

As illustrated in FIG. 17, the specific region where the print layer 3 is formed may be set as a partial region of the film 4, and printing may be performed with a different transparency T and/or color from the print layer 3 in a designated region R that is a different region from the specific region. Such composite printing can be performed as outlined below, for example. First, masking of the film 4 is performed so as to exclude the designated region R from the printing subject. This masking can be performed using a first masking material 6 that is temporarily affixed to the designated region R. Printing is performed for a first time with respect to all regions of the film 4 in a state in which this masking has been performed, and then the first masking material 6 is removed so as to form the print layer 3 in only the specific region, which is exclusive of the designated region R. Next, masking of the film 4 is performed for a second time so as to exclude the specific region from the printing subject. This second masking can be performed using a second masking material 7 that is temporarily affixed to the specific region. Printing is performed for a second time with respect to all regions of the film 4 in a state in which the second masking has been performed, and then the second masking material 7 is removed to thereby enable formation of printing with a different transparency T and/or color from the print layer 3 in only the designated region R, which is exclusive of the specific region.

Although the results of investigation related to power generation performance and design properties (visibility) described above are for a case in which the print layer 3 is formed on the film 4 that is affixed onto the substrate 2b that is at the light-receiving surface side, these results are also applicable for a case in which the print layer 3 is formed on the substrate 2b that is at the light-receiving surface side without the film 4 in-between because the effects on power generation performance and design properties of the film 4 and the adhesive layer 5 for affixing thereof are negligible. In other words, the solar cell module 1 according to the present embodiment can be changed to a configuration in which the print layer 3 is formed on the substrate 2b that is at the light-receiving surface side.

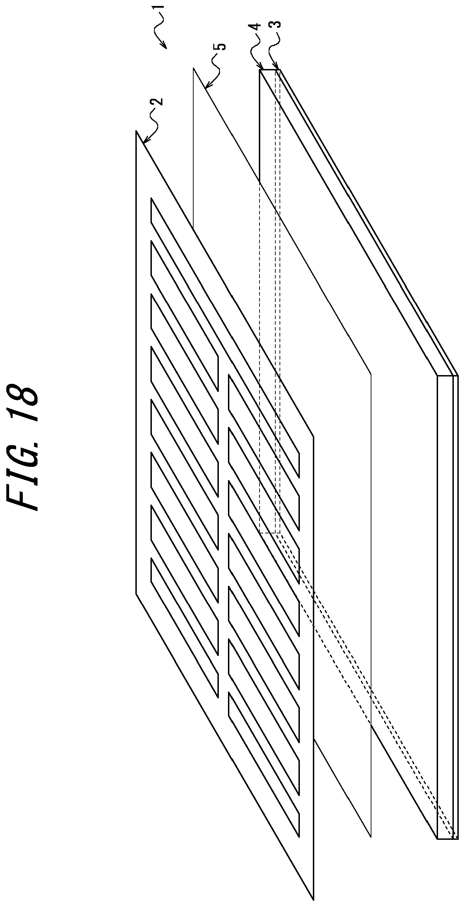

The following describes a solar cell module 1 according to a second embodiment of the present disclosure. As illustrated in FIG. 18, the solar cell module 1 according to the present embodiment includes a solar cell module body 2 and a print layer 3 formed further toward a rear surface side that is an opposite side to a light-receiving surface side than the solar cell module body 2 by printing with a specific transparency T in a specific region, and has a configuration in which the light-receiving surface side is visible from the rear surface side in at least part of the specific region. The specific transparency T is set such that at least one of the condition A, the condition B, the condition C, and the condition D described above is satisfied in a case in which the print layer 3 is provided at the light-receiving surface side instead of the rear surface side. Note that elements corresponding to elements presented in the first embodiment are allotted the same reference signs in FIG. 18.

A configuration such as set forth above makes it possible to obtain excellent design properties suitable for use with the solar cell module 1 according to the first embodiment through printing being performed at the rear surface side with the same level of transparency T as for the solar cell module 1 according to the first embodiment while also enabling visibility through to the light-receiving surface side. In other words, the solar cell module 1 according to the second embodiment has design properties harmonized with the solar cell module 1 according to the first embodiment.

In this manner, a solar cell module 1 according to the second embodiment that has excellent design properties suitable for use with the solar cell module 1 according to the first embodiment can be produced by setting the specific transparency T such that at least one of the condition A, the condition B, the condition, C, and the condition D described above is satisfied in a case in which the print layer 3 is provided at the light-receiving surface side instead of the rear surface side. Moreover, in production of the solar cell module 1 according to the second embodiment, production can be facilitated by adopting the condition B as compared to the condition A, by adopting the condition C as compared to the condition B, and by adopting the condition D as compared to the condition C.

It should be noted that although the print layer 3 is formed on a film 4 that is affixed onto a substrate 2b that is at the rear surface side in the present embodiment, the print layer 3 may be formed on the substrate 2b that is at the rear surface side in the same way as for the first embodiment.

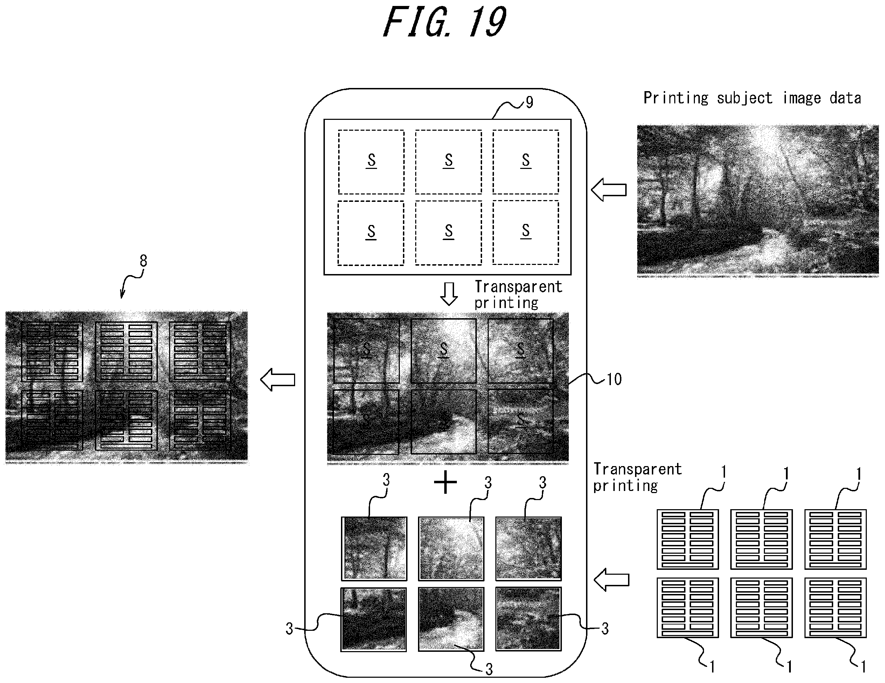

The following describes a panel 8 according to one embodiment of the present disclosure with reference to FIG. 19.

As illustrated in FIG. 19, the panel 8 according to the present embodiment includes a plurality of solar cell modules 1 and a sheet 9 having the plurality of solar cell modules 1 affixed in a partial region (affixing regions S). The sheet 9 includes a sheet print layer 10 that is a print layer that is formed in a different region from the affixing regions S and in which printing of a specific image P straddling print layers 3 of the plurality of solar cell modules 1 is formed. The sheet 9 is formed of a flexible sheet having transparency, for example. In a case in which the sheet 9 is formed of such a flexible sheet, wiring for the solar cell modules 1 may be included in the flexible sheet.

Although the number of solar cell modules 1 in the present embodiment is 6, the number of solar cell modules 1 may be one or more. Moreover, the plurality of solar cell modules 1 can be configured as any combination of the solar cell module 1 according to the first embodiment (or any of various modified examples thereof such as previously described) and the solar cell module 1 according to the second embodiment (or any of various modified examples thereof such as previously described).

The panel 8 according to the present embodiment makes it possible to obtain excellent design properties because printing can be performed for a large screen that is a combination of the print layers 3 of the plurality of solar cell modules 1 and the sheet print layer 10 of the sheet 9.

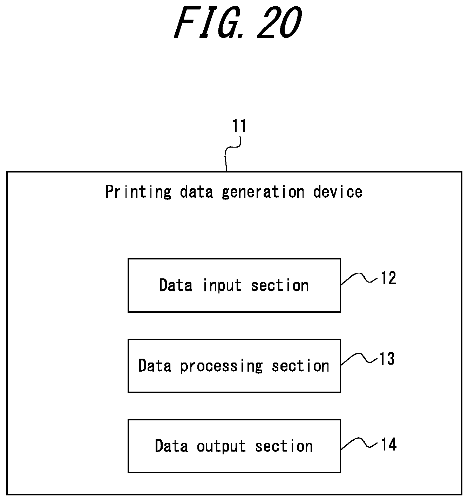

The following describes a printing data generation device 11 according to one embodiment of the present disclosure with reference to FIG. 20. The printing data generation device 11 according to the present embodiment generates printing data for printing a specific image P in the panel 8 described above. The printing data generation device 11 can be configured as a computer including a processor and memory, for example. The printing data generation device 11 according to the present embodiment includes a data input section 12, a data processing section 13, and a data output section 14 as illustrated in FIG. 20.

The data input section 12 is configured to enable input of data corresponding to the specific image P that is to be printed in the panel 8, information related to the sheet 9 used to form the panel 8 (shape, size, etc. of sheet 9), and information related to the solar cell modules 1 used to form the panel 8 (number, shape, size, arrangement, etc. of solar cell modules 1). Note that input to the data input section 12 may be performed by a person through an interface such as a keyboard or may be performed automatically by AI or the like.

The data processing section 13 is configured to obtain printing data corresponding to one part of the specific image P from data corresponding to the specific image P in order to form the print layers 3 of the solar cell modules 1 that are to display only the one part of the specific image P and to obtain printing data corresponding to another part of the specific image P from data corresponding to the specific image P in order to form the sheet print layer 10 of the sheet 9 that is to display only the other part of the specific image P.

The data output section 14 is configured to enable output of printing data obtained by the data processing section 13 to a printer.

Accordingly, the printing data generation device 11 according to the present embodiment makes it possible to easily obtain printing data corresponding to each of the plurality of solar cell modules 1 and the sheet 9, thereby making it possible to easily generate printing data for printing the specific image P in the panel 8.

The embodiments described above are merely examples of embodiments of the present disclosure and various alterations can be made that do not deviate from the essence of the present disclosure.

Accordingly, various alterations such as described below, for example, can be made to the solar cell module 1, panel 8, and printing data generation device 11 of the above-described embodiments.

Various alterations can be made to a solar cell module 1 according to a first aspect of the first embodiment so long as the solar cell module 1 includes a solar cell module body 2 and a print layer 3 formed further toward a light-receiving surface side than the solar cell module body 2 by printing with a specific transparency T in a specific region, a rear surface side is visible from the light-receiving surface side in at least part of the specific region, and the specific transparency T is set such that the condition A is satisfied.

Various alterations can be made to a solar cell module 1 according to a second aspect of the first embodiment so long as the solar cell module 1 includes a solar cell module body 2 and a print layer 3 formed further toward a light-receiving surface side than the solar cell module body 2 by full color, red monochrome, green monochrome, or blue monochrome printing with a specific transparency T in a specific region, a rear surface side is visible from the light-receiving surface side in at least part of the specific region, and the specific transparency T is set such that the condition B is satisfied.

Various alterations can be made to a solar cell module 1 according to a third aspect of the first embodiment so long as the solar cell module 1 includes a solar cell module body 2 and a print layer 3 formed further toward a light-receiving surface side than the solar cell module body 2 by red monochrome, green monochrome, or blue monochrome printing with a specific transparency T in a specific region, a rear surface side is visible from the light-receiving surface side in at least part of the specific region, and the specific transparency T is set such that the condition C is satisfied.

Various alterations can be made to a solar cell module 1 according to a fourth aspect of the first embodiment so long as the solar cell module 1 includes a solar cell module body 2 and a print layer 3 formed further toward a light-receiving surface side than the solar cell module body 2 by red monochrome, green monochrome, or blue monochrome printing with a specific transparency T in a specific region, a rear surface side is visible from the light-receiving surface side in at least part of the specific region, and the specific transparency T is set such that the condition D is satisfied.

However, in the solar cell module 1 according to the first embodiment, it is preferable that the solar cell module body 2 includes a pair of substrates 2b sandwiching at least one power-generating cell 2a and that the print layer 3 is formed on a substrate 2b that is at the light-receiving surface side.

Moreover, in the solar cell module 1 according to the first embodiment, it is preferable that the solar cell module body 2 includes a pair of substrates 2b sandwiching at least one power-generating cell 2a and that the print layer 3 is formed on a film 4 that is affixed onto a substrate 2b that is at the light-receiving surface side.

In the solar cell module 1 according to the first embodiment, it is preferable that an adhesive layer 5 adhering the film 4 onto the substrate 2b that is at the light-receiving surface side is included and that the adhesive layer 5 is a film-shaped adhesive sheet having an ultraviolet filter function of blocking ultraviolet light having a wavelength of shorter than 400 nm.

In the solar cell module 1 according to the first embodiment, it is preferable that printing is performed with a different transparency T and/or color from the print layer 3 in a different region (designated region R) from the specific region at a surface where the print layer 3 is formed.

In the solar cell module 1 according to the first embodiment, it is preferable that the solar cell module body 2 is configured as a dye-sensitized solar cell.

Moreover, various alterations can be made to a solar cell module 1 according to the second embodiment so long as the solar cell module 1 includes a solar cell module body 2 and a print layer 3 formed further toward a rear surface side that is an opposite side to a light-receiving surface side than the solar cell module body 2 by printing with a specific transparency T in a specific region, the light-receiving surface side is visible from the rear surface side in at least part of the specific region, and the specific transparency T is set such that at least one of the condition A, the condition B, the condition C, and the condition D is satisfied in a case in which the print layer 3 is provided at the light-receiving surface side instead of the rear surface side.

Furthermore, various alterations can be made to a panel 8 according to the previously described embodiment so long as the panel 8 includes a solar cell module 1 and a sheet 9 having the solar cell module 1 affixed in a partial region (affixing region S), and the sheet 9 includes a print layer (sheet print layer 10) that is formed in a different region from the partial region and in which printing straddling a print layer 3 of the solar cell module 1 is formed.

Also, various alterations can be made to a printing data generation device 11 according to the previously described embodiment so long as the printing data generation device 11 generates printing data for printing only part of a specific image P in a solar cell module 1 and includes a data processing section 13 that obtains printing data corresponding to the one part of the specific image P from data corresponding to the specific image P in order to form a print layer 3.

However, it is preferable that the printing data generation device 11 generates printing data for printing a specific image P in a panel 8 and includes a data processing section 13 that obtains printing data corresponding to one part of the specific image P from data corresponding to the specific image P in order to form a print layer 3 of a solar cell module 1 that is to display only the one part of the specific image P and that obtains printing data corresponding to another part of the specific image P from data corresponding to the specific image P in order to form a print layer (sheet print layer 10) of a sheet 9 that is to display only the other part of the specific image P.

INDUSTRIAL APPLICABILITY

According to the present disclosure, it is possible to provide a solar cell module corresponding to the first object.

Moreover, according to the present disclosure, it is possible to provide a solar cell module corresponding to the second object.

Furthermore, according to the present disclosure, it is possible to provide a panel corresponding to the third object.

Also, according to the present disclosure, it is possible to provide a printing data generation device corresponding to the fourth object.

REFERENCE SIGNS LIST

1 solar cell module
2 solar cell module body
2a power-generating cell
2b substrate
2c conductive film
2d porous semiconductor layer
2e catalyst layer
2f charge transport layer
2g adhesive layer
2h wiring structure
2i current-collecting electrode
2j terminal
3 print layer
4 film
5 adhesive layer
6 first masking material
7 second masking material
8 panel
9 sheet
10 sheet print layer
11 printing data generation device
12 data input section
13 data processing section
14 data output section
P specific image
R designated region
S affixing region
T transparency

**Claims**

1. A solar cell module (1) comprising: a solar cell module body (2) defined as a pair of substrates sandwiching at least one power-generating cell or configured as a dye-sensitized solar cell; and a print layer (3) that is formed further toward a light-receiving surface side than the solar cell module body (2) by printing with a specific transparency in a specific region, wherein

    a rear surface side of the solar cell module is visible from the light-receiving surface side in at least part of the specific region, and
    the specific transparency is set such that a condition A is satisfied, the condition A being that a spectral sensitivity integral ratio A defined by formula (1), shown below, is not less than a specific value A* that the spectral sensitivity integral ratio A takes when printing is performed with a transparency resulting in a short circuit current ratio of 0.6,
    [numerical 1]

$$A = \frac{\int_{360}^{830}(f(\lambda))d\lambda}{\int_{360}^{830}(f_{SC}(\lambda))d\lambda} \quad \cdots \quad \text{Formula (1)}$$

    where $\lambda$ is wavelength, in units of nm,
    $f(\lambda)$ is quantum efficiency IPCE, in units of %, in a case in which the print layer is formed, and
    $f_{sc}(\lambda)$ is quantum efficiency IPCE, in units of %, in a case in which the print layer is not formed.

2. A solar cell module (1) comprising: a solar cell module body (2) defined as a pair of substrates sandwiching at least one power-generating cell or configured as a dye-sensitized solar cell; and a print layer (3) that is formed further toward a light-receiving surface side than the solar cell module body (2) by full color, red monochrome, green monochrome, or blue monochrome printing with a specific transparency in a specific region, wherein

    a rear surface side of the solar cell module is visible from the light-receiving surface side in at least part of the specific region, and
    the specific transparency is set such that a condition B is satisfied, the condition B being that:

        a spectral sensitivity integral ratio $A_K$ defined by formula (2), shown below, is 0.50 or more in a case in which the print layer is full color;
        a spectral sensitivity integral ratio $A_R$ defined by formula (3), shown below, is 0.47 or more in a case in which the print layer is red monochrome;
        a spectral sensitivity integral ratio $A_G$ defined by formula (4), shown below, is 0.60 or more in a case in which the print layer is green monochrome; and
        a spectral sensitivity integral ratio $A_B$ defined by formula (5), shown below, is 0.63 or more in a case in which the print layer is blue monochrome,
        [numerical 2]

$$A_K = \frac{\int_{400}^{700}(f_K(\lambda))d\lambda}{\int_{400}^{700}(f_{SC}(\lambda))d\lambda} \quad \cdots \quad \text{Formula (2)}$$

        [numerical 3]

$$A_R = \frac{\int_{400}^{700}(f_R(\lambda))d\lambda}{\int_{400}^{700}(f_{SC}(\lambda))d\lambda} \quad \cdots \quad \text{Formula (3)}$$

[numerical 4]

$$A_G = \frac{\int_{400}^{700}(f_G(\lambda))d\lambda}{\int_{400}^{700}(f_{SC}(\lambda))d\lambda} \quad \cdots \quad \text{Formula (4)}$$

[numerical 5]

$$A_B = \frac{\int_{400}^{700}(f_B(\lambda))d\lambda}{\int_{400}^{700}(f_{SC}(\lambda))d\lambda} \quad \cdots \quad \text{Formula (5)}$$

where $f_K(\lambda)$ is quantum efficiency IPCE, in units of %, in a case in which the print layer is formed by black whole surface printing,

$f_R(\lambda)$ is quantum efficiency IPCE, in units of %, in a case in which the print layer is formed by red monochrome whole surface printing,

$f_G(\lambda)$ is quantum efficiency IPCE, in units of %, in a case in which the print layer is formed by green monochrome whole surface printing, and

$f_B(\lambda)$ is quantum efficiency IPCE, in units of %, in a case in which the print layer is formed by blue monochrome whole surface printing.

3. A solar cell module (1) comprising: a solar cell module body (2) defined as a pair of substrates sandwiching at least one power-generating cell or configured as a dye-sensitized solar cell; and a print layer (3) that is formed further toward a light-receiving surface side than the solar cell module body (2) by red monochrome, green monochrome, or blue monochrome printing with a specific transparency in a specific region, wherein

a rear surface side of the solar cell module is visible from the light-receiving surface side in at least part of the specific region, and
the specific transparency is set such that a condition C is satisfied, the condition C being that:

a red designated wavelength spectral sensitivity integral ratio $B_R$ defined by formula (6), shown below, is 0.18 or more, a red non-designated wavelength spectral sensitivity integral ratio $C_R$ defined by formula (7), shown below, is 0.29 or more, and a red spectral sensitivity peak ratio $P_R$ defined by formula (8), shown below, is 0.70 or more in a case in which the print layer is red monochrome;
a green designated wavelength spectral sensitivity integral ratio $B_G$ defined by formula (9), shown below, is 0.37 or more, a green non-designated wavelength spectral sensitivity integral ratio $C_G$ defined by formula (10), shown below, is 0.23 or more, and a green spectral sensitivity peak ratio $P_G$ defined by formula (11), shown below, is 0.78 or more in a case in which the print layer is green monochrome; and
a blue designated wavelength spectral sensitivity integral ratio $B_B$ defined by formula (12), shown below, is 0.38 or more, a blue non-designated wavelength spectral sensitivity integral ratio $C_B$ defined by formula (13), shown below, is 0.25 or more, and a blue spectral sensitivity peak ratio $P_B$ defined by formula (14), shown below, is 0.77 or more in a case in which the print layer is blue monochrome,
[numerical 6]

$$B_R = \frac{\int_{560}^{660}(f_R(\lambda))d\lambda}{\int_{400}^{700}(f_{SC}(\lambda))d\lambda} \quad \cdots \quad \text{Formula (6)}$$

[numerical 7]

$$C_R = \frac{\int_{400}^{560}(f_R(\lambda))d\lambda}{\int_{400}^{700}(f_{SC}(\lambda))d\lambda} + \frac{\int_{660}^{700}(f_R(\lambda))d\lambda}{\int_{400}^{700}(f_{SC}(\lambda))d\lambda} \quad \cdots \quad \text{Formula (7)}$$

[numerical 8]

$$P_R = \frac{f_R(\lambda_{RP})}{f_{SC}(\lambda_{RP})} \quad \cdots \quad \text{Formula (8)}$$

[numerical 9]

$$B_G = \frac{\int_{480}^{580}(f_G(\lambda))d\lambda}{\int_{400}^{700}(f_{SC}(\lambda))d\lambda} \quad \cdots \quad \text{Formula (9)}$$

[numerical 10]

$$C_G = \frac{\int_{400}^{480}(f_G(\lambda))d\lambda}{\int_{400}^{700}(f_{SC}(\lambda))d\lambda} + \frac{\int_{580}^{700}(f_G(\lambda))d\lambda}{\int_{400}^{700}(f_{SC}(\lambda))d\lambda} \quad \cdots \quad \text{Formula (10)}$$

[numerical 11]

$$P_G = \frac{f_G(\lambda_{GP})}{f_{SC}(\lambda_{GP})} \quad \cdots \quad \text{Formula (11)}$$

[numerical 12]

$$B_B = \frac{\int_{430}^{530}(f_B(\lambda))d\lambda}{\int_{400}^{700}(f_{SC}(\lambda))d\lambda} \quad \cdots \quad \text{Formula (12)}$$

[numerical 13]

$$C_B = \frac{\int_{400}^{430}(f_B(\lambda))d\lambda}{\int_{400}^{700}(f_{SC}(\lambda))d\lambda} + \frac{\int_{530}^{700}(f_B(\lambda))d\lambda}{\int_{400}^{700}(f_{SC}(\lambda))d\lambda} \quad \cdots \text{ Formula (13)}$$

[numerical 14]

$$P_B = \frac{f_B(\lambda_{BP})}{f_{SC}(\lambda_{BP})} \quad \cdots \text{ Formula (14)}$$

where $\lambda_{RP}$ is $\lambda$ when $f_R(\lambda)$ is at a peak in a red designated wavelength interval of 560 nm $\leq \lambda \leq$ 660 nm, $\lambda_{GP}$ is $\lambda$ when $f_G(\lambda)$ is at a peak in a green designated wavelength interval of 480 nm $\leq \lambda \leq$ 580 nm, and $\lambda_{BP}$ is $\lambda$ when $f_B(\lambda)$ is at a peak in a blue designated wavelength interval of 430 nm $\leq \lambda \leq$ 530 nm.

4. The solar cell module (1) according to any one of claims 1 to 3, wherein

   the solar cell module body (2) includes a pair of substrates sandwiching at least one power-generating cell, and the print layer is formed on a substrate that is at the light-receiving surface side.

5. The solar cell module (1) according to any one of claims 1 to 3, wherein

   the solar cell module body (2) includes a pair of substrates sandwiching at least one power-generating cell, and the print layer is formed on a film that is affixed onto a substrate that is at the light-receiving surface side.

6. The solar cell module (1) according to claim 5, further comprising an adhesive layer that adheres the film onto the substrate that is at the light-receiving surface side, wherein
   the adhesive layer is a film-shaped adhesive sheet that has an ultraviolet filter function of blocking ultraviolet light having a wavelength of shorter than 400 nm.

7. The solar cell module (1) according to any one of claims 1 to 6, wherein printing is performed with either or both of a different transparency and a different color from the print layer in a different region from the specific region at a surface where the print layer is formed.

8. The solar cell module (1) according to any one of claims 1 to 7, wherein the solar cell module body (2) is configured as a dye-sensitized solar cell.

9. A solar cell module (1) comprising: a solar cell module body (2) defined as a pair of substrates sandwiching at least one power-generating cell or configured as a dye-sensitized solar cell; and a print layer (3) formed further toward a rear surface side of the solar cell module that is an opposite side to a light-receiving surface side than the solar cell module body by printing with a specific transparency in a specific region, wherein

   the light-receiving surface side is visible from the rear surface side in at least part of the specific region, and the specific transparency is set such that at least one of the condition A according to claim 1, the condition B according to claim 2, and the condition C according to claim 3 is satisfied for the print layer (3) formed at the rear surface side.

10. A panel comprising:

    the solar cell module (1) according to any one of claims 1 to 9; and
    a sheet having the solar cell module (1) affixed in a partial region, wherein
    the sheet includes a print layer that is formed in a different region from the partial region and in which printing straddling the print layer of the solar cell module is formed.

11. A printing data generation device (11) that generates printing data for printing only one part of a specific image in the solar cell module (1) according to any one of claims 1 to 9, comprising a data processing section (13) that obtains printing data corresponding to the one part of the specific image from data corresponding to the specific image in order to form the print layer (3).

12. A printing data generation device (11) that generates printing data for printing a specific image in the panel according to claim 10, comprising a data processing section (13) that obtains printing data corresponding to one part of the specific image from data corresponding to the specific image in order to form the print layer of the solar cell module that is to display only the one part of the specific image and that obtains printing data corresponding to another part of the specific image from data corresponding to the specific image in order to form the print layer of the sheet that is to display only the other part of the specific image.

**Patentansprüche**

1. Solarzellenmodul (1), umfassend: einen Solarzellenmodulkörper (2), der als ein Paar von Substraten definiert ist, die mindestens eine stromerzeugende Zelle sandwichartig einschließen oder als Farbstoffsolarzelle konfiguriert sind; und eine Druckschicht (3), die weiter in Richtung einer lichtempfangenden Oberflächenseite als der Solarzellenmodulkörper (2) durch Drucken mit einer spezifischen Transparenz in einem spezifischen Bereich gebildet ist, wobei

   eine hintere Oberflächenseite des Solarzellenmoduls von der lichtempfangenden Oberflächenseite in mindestens einem Teil des spezifischen Bereichs sichtbar ist, und
   die spezifische Transparenz so eingestellt ist, dass eine Bedingung A erfüllt ist, wobei die Bedingung A darin besteht, dass ein spektrales Empfindlichkeitsintegralverhältnis A, das durch die unten gezeigte Formel (1) definiert ist, nicht kleiner ist als ein spezifischer Wert A*, den das spektrale Empfindlichkeitsintegralverhältnis A annimmt, wenn mit einer Transparenz gedruckt wird, die zu einem Kurzschlussstromverhältnis von 0,6 führt,
   [numerisch 1]

$$A = \frac{\int_{360}^{830}(f(\lambda))d\lambda}{\int_{360}^{830}(f_{SC}(\lambda))d\lambda} \quad \cdots$$

$$\text{Formel (1)}$$

   wobei $\lambda$ die Wellenlänge in Einheiten von nm ist,
   $f(\lambda)$ die Quanteneffizienz IPCE in Einheiten von %, in einem Fall ist, dass die Druckschicht gebildet wird, und
   $f_{sc}(\lambda)$ die Quanteneffizienz IPCE, in Einheiten von %, in einem Fall ist, in dem die Druckschicht nicht gebildet wird.

2. Solarzellenmodul (1), umfassend: einen Solarzellenmodulkörper (2), der als ein Paar von Substraten definiert ist, zwischen denen sich mindestens eine stromerzeugende Zelle befindet, oder der als eine farbstoffsensibilisierte Solarzelle konfiguriert ist; und eine Druckschicht (3), die weiter in Richtung einer lichtempfangenden Oberflächenseite als der Solarzellenmodulkörper (2) durch Vollfarb-, Rot-Monochrom-, Grün-Monochrom- oder Blau-MonochromDruck mit einer spezifischen Transparenz in einem spezifischen Bereich gebildet ist, wobei

   eine rückwärtige Oberflächenseite des Solarzellenmoduls von der lichtempfangenden Oberflächenseite in zumindest einem Teil des spezifischen Bereichs sichtbar ist, und
   die spezifische Transparenz so eingestellt ist, dass eine Bedingung B erfüllt ist, wobei die Bedingung B lautet, dass:

      ein spektrales Empfindlichkeitsintegralverhältnis $A_K$, das durch die unten dargestellte Formel (2) definiert ist, in einem Fall, in dem die Druckschicht vollfarbig ist, 0,50 oder mehr beträgt;
      ein spektrales Empfindlichkeitsintegralverhältnis $A_R$, definiert durch die unten gezeigte Formel (3), 0,47 oder mehr beträgt, wenn die Druckschicht rot monochrom ist;
      ein spektrales Empfindlichkeitsintegralverhältnis $A_G$, definiert durch die unten gezeigte Formel (4), ist 0,60 oder mehr in einem Fall, in dem die Druckschicht grün monochrom ist; und
      ein spektrales Empfindlichkeitsintegralverhältnis $A_B$, definiert durch die unten gezeigte Formel (5), 0,63 oder mehr beträgt, wenn die Druckschicht blau monochrom ist,
      [numerisch 2]

$$A_K = \frac{\int_{400}^{700}(f_K(\lambda))d\lambda}{\int_{400}^{700}(f_{SC}(\lambda))d\lambda} \quad \cdots \qquad \text{Formel (2)}$$

[numerisch 3]

$$A_R = \frac{\int_{400}^{700}(f_R(\lambda))d\lambda}{\int_{400}^{700}(f_{SC}(\lambda))d\lambda} \quad \cdots \qquad \text{Formel (3)}$$

[numerisch 4]

$$A_G = \frac{\int_{400}^{700}(f_G(\lambda))d\lambda}{\int_{400}^{700}(f_{SC}(\lambda))d\lambda} \quad \cdots \qquad \text{Formel (4)}$$

[numerisch 5]

$$A_B = \frac{\int_{400}^{700}(f_B(\lambda))d\lambda}{\int_{400}^{700}(f_{SC}(\lambda))d\lambda} \quad \cdots \qquad \text{Formel (5)}$$

wobei $f_K(\lambda)$ der Quantenwirkungsgrad IPCE in % in einem Fall ist, in dem die Druckschicht durch ganzflächigen Schwarzdruck gebildet wird,

$f_R(\lambda)$ ist der Quantenwirkungsgrad IPCE in % für den Fall, dass die Druckschicht durch ganzflächigen roten Monochromdruck erzeugt wird,

$f_G(\lambda)$ ist der Quantenwirkungsgrad IPCE in % für den Fall, dass die Druckschicht durch ganzflächigen grünen Monochromdruck gebildet wird, und

$f_B(\lambda)$ ist die Quanteneffizienz IPCE in %-Einheiten für den Fall, dass die Druckschicht durch ganzflächigen blauen Monochromdruck gebildet wird.

3. Solarzellenmodul (1), umfassend: einen Solarzellenmodulkörper (2), der als ein Paar von Substraten definiert ist, zwischen denen sich mindestens eine stromerzeugende Zelle befindet, oder der als farbstoffsensibilisierte Solarzelle konfiguriert ist; und eine Druckschicht (3), die weiter in Richtung einer lichtempfangenden Oberflächenseite als der Solarzellenmodulkörper (2) durch rotes monochromes, grünes monochromes oder blaues monochromes Drucken mit einer spezifischen Transparenz in einem spezifischen Bereich gebildet ist, wobei

eine rückwärtige Oberflächenseite des Solarzellenmoduls von der lichtempfangenden Oberflächenseite in zumindest einem Teil des spezifischen Bereichs sichtbar ist, und
die spezifische Transparenz so eingestellt ist, dass eine Bedingung C erfüllt ist, wobei die Bedingung C lautet, dass:

ein Integralverhältnis der spektralen Empfindlichkeit für rote bezeichnete Wellenlängen $B_R$, definiert durch die unten gezeigte Formel (6), 0,18 oder mehr beträgt, ein Integralverhältnis der spektralen Empfindlichkeit für rote nicht bezeichnete Wellenlängen $C_R$, definiert durch die unten gezeigte Formel (7), 0,29 oder mehr beträgt, und ein Spitzenverhältnis der spektralen Empfindlichkeit für rote Wellenlängen $P_R$, definiert durch die unten gezeigte Formel (8), 0,70 oder mehr beträgt, in einem Fall, in dem die Druckschicht rot monochrom ist;

ein grünes bezeichnetes Wellenlängen-SpektralempfindlichkeitsIntegralverhältnis $B_G$, das durch die unten gezeigte Formel (9) definiert ist, 0,37 oder mehr beträgt, ein grünes nicht-bezeichnetes Wellenlängen-Spektralempfindlichkeits-Integralverhältnis $C_G$, das durch die unten gezeigte Formel (10) definiert ist, 0,23 oder mehr beträgt und ein grünes Spektralempfindlichkeits-Spitzenverhältnis $P_G$, das durch die unten gezeigte Formel (11) definiert ist, 0,78 oder mehr beträgt, wenn die Druckschicht grün monochrom ist; und

ein blaues Spektralempfindlichkeitsintegralverhältnis $B_B$, das durch die unten gezeigte Formel (12) definiert ist, 0,38 oder mehr beträgt, ein blaues Spektralempfindlichkeitsintegralverhältnis $C_B$, das nicht durch die unten gezeigte Formel (13) definiert ist, 0,25 oder mehr beträgt und ein blaues Spektralempfindlichkeitsspitzenverhältnis $P_B$, das durch die unten gezeigte Formel (14) definiert ist, 0,77 oder mehr beträgt, wenn die Druckschicht blau monochrom ist,

[numerisch 6]

$$B_R = \frac{\int_{560}^{660}(f_R(\lambda))d\lambda}{\int_{400}^{700}(f_{SC}(\lambda))d\lambda} \quad \cdots \qquad Formel\ (6)$$

[numerisch 7]

$$C_R = \frac{\int_{400}^{560}(f_R(\lambda))d\lambda}{\int_{400}^{700}(f_{SC}(\lambda))d\lambda} + \frac{\int_{660}^{700}(f_R(\lambda))d\lambda}{\int_{400}^{700}(f_{SC}(\lambda))d\lambda} \quad \cdots \qquad Formel\ (7)$$

[numerisch 8]

$$P_R = \frac{f_R(\lambda_{RP})}{f_{SC}(\lambda_{RP})} \quad \cdots \qquad Formel\ (8)$$

[numerisch 9]

$$B_G = \frac{\int_{480}^{580}(f_G(\lambda))d\lambda}{\int_{400}^{700}(f_{SC}(\lambda))d\lambda} \quad \cdots \qquad Formel\ (9)$$

[numerisch 10]

$$C_G = \frac{\int_{400}^{480}(f_G(\lambda))d\lambda}{\int_{400}^{700}(f_{SC}(\lambda))d\lambda} + \frac{\int_{580}^{700}(f_G(\lambda))d\lambda}{\int_{400}^{700}(f_{SC}(\lambda))d\lambda} \quad \cdots \qquad Formel\ (10)$$

[numerisch 11]

$$P_G = \frac{f_G(\lambda_{GP})}{f_{SC}(\lambda_{GP})} \quad \cdots$$

$$\text{Formel (11)}$$

[numerisch 12]

$$B_B = \frac{\int_{430}^{530}(f_B(\lambda))d\lambda}{\int_{400}^{700}(f_{SC}(\lambda))d\lambda} \quad \cdots$$

$$\text{Formel (12)}$$

[numerisch 13]

$$C_B = \frac{\int_{400}^{430}(f_B(\lambda))d\lambda}{\int_{400}^{700}(f_{SC}(\lambda))d\lambda} + \frac{\int_{530}^{700}(f_B(\lambda))d\lambda}{\int_{400}^{700}(f_{SC}(\lambda))d\lambda} \quad \cdots$$

$$\text{Formel (13)}$$

[numerisch 14]

$$P_B = \frac{f_B(\lambda_{BP})}{f_{SC}(\lambda_{BP})} \quad \cdots$$

$$\text{Formel (14)}$$

wobei $\lambda_{RP}$ $\lambda$ ist, wenn $f_R(\lambda)$ einen Spitzenwert in einem rot bezeichneten Wellenlängenintervall von 560 nm $\leq$ $\lambda \leq$ 660 nm hat,

$\lambda_{GP}$ ist $\lambda$, wenn $f_G(\lambda)$ einen Spitzenwert in einem grün bezeichneten Wellenlängenintervall von 480 nm $\leq \lambda \leq$ 580 nm hat, und

$\lambda_{BP}$ ist $\lambda$, wenn $f_B(\lambda)$ einen Spitzenwert in einem blau bezeichneten Wellenlängenintervall von 430 nm $\leq \lambda \leq$ 530 nm hat.

4. Solarzellenmodul (1) nach einem der Ansprüche 1 bis 3, wobei

   der Solarzellenmodulkörper (2) ein Paar von Substraten umfasst, die mindestens eine stromerzeugende Zelle einschließen, und
   die Druckschicht auf einem Substrat ausgebildet ist, das sich auf der Seite der lichtempfangenden Oberfläche befindet.

5. Solarzellenmodul (1) nach einem der Ansprüche 1 bis 3, wobei

   der Solarzellenmodulkörper (2) ein Paar von Substraten umfasst, die mindestens eine stromerzeugende Zelle sandwichartig einschließen, und
   die Druckschicht auf einem Film ausgebildet ist, der auf einem Substrat befestigt ist, das sich auf der Seite der lichtempfangenden Oberfläche befindet.

6. Solarzellenmodul (1) nach Anspruch 5, ferner umfassend eine Klebeschicht, die den Film auf das Substrat auf der Seite der lichtempfangenden Oberfläche klebt, wobei
   die Klebeschicht eine folienförmige Klebefolie ist, die eine Ultraviolett-Filterfunktion zum Blockieren von ultraviolettem Licht mit einer Wellenlänge von kürzer als 400 nm aufweist.

**7.** Solarzellenmodul (1) nach einem der Ansprüche 1 bis 6, wobei das Bedrucken mit entweder einer anderen Transparenz oder einer anderen Farbe als die Druckschicht in einem anderen Bereich als dem spezifischen Bereich an einer Oberfläche, an der die Druckschicht ausgebildet ist, durchgeführt wird.

**8.** Solarzellenmodul (1) nach einem der Ansprüche 1 bis 7, wobei der Solarzellenmodulkörper (2) als farbstoffsensibilisierte Solarzelle ausgebildet ist.

**9.** Solarzellenmodul (1), umfassend: einen Solarzellenmodulkörper (2), der als ein Paar von Substraten definiert ist, zwischen denen sich mindestens eine stromerzeugende Zelle befindet, oder der als farbstoffsensibilisierte Solarzelle konfiguriert ist; und eine Druckschicht (3), die weiter in Richtung einer hinteren Oberflächenseite des Solarzellenmoduls gebildet ist, die eine gegenüberliegende Seite zu einer lichtempfangenden Oberflächenseite als der Solarzellenmodulkörper ist, durch Drucken mit einer spezifischen Transparenz in einem spezifischen Bereich, wobei

die lichtempfangende Oberflächenseite von der rückwärtigen Oberflächenseite in zumindest einem Teil des spezifischen Bereichs sichtbar ist, und
die spezifische Transparenz so eingestellt ist, dass mindestens eine der Bedingungen A nach Anspruch 1, B nach Anspruch 2 und C nach Anspruch 3 für die auf der Rückseite gebildete Druckschicht (3) erfüllt ist.

**10.** Paneel, umfassend:

das Solarzellenmodul (1) nach einem der Ansprüche 1 bis 9; und
eine Folie, auf der das Solarzellenmodul (1) in einem Teilbereich befestigt ist, wobei
das Blatt eine Druckschicht enthält, die in einem anderen Bereich als dem Teilbereich ausgebildet ist und in der ein die Druckschicht des Solarzellenmoduls übergreifender Druck ausgebildet ist.

**11.** Druckdatenerzeugungsvorrichtung (11), die Druckdaten zum Drucken nur eines Teils eines bestimmten Bildes im Solarzellenmodul (1) nach einem der Ansprüche 1 bis 9 erzeugt, mit einem Datenverarbeitungsabschnitt (13), der aus Daten, die dem bestimmten Bild entsprechen, Druckdaten entsprechend dem einen Teil des bestimmten Bildes gewinnt, um die Druckschicht (3) zu bilden.

**12.** Druckdatenerzeugungsvorrichtung (11), die Druckdaten zum Drucken eines spezifischen Bildes in der Platte nach Anspruch 10 erzeugt, mit einem Datenverarbeitungsabschnitt (13), der aus Daten, die dem spezifischen Bild entsprechen, Druckdaten gewinnt, die einem Teil des spezifischen Bildes entsprechen, um die Druckschicht des Solarzellenmoduls zu bilden, die nur den einen Teil des spezifischen Bildes anzeigen soll, und der aus Daten, die dem spezifischen Bild entsprechen, Druckdaten gewinnt, die einem anderen Teil des spezifischen Bildes entsprechen, um die Druckschicht der Platte zu bilden, die nur den anderen Teil des spezifischen Bildes anzeigen soll.

**Revendications**

**1.** Module de cellule solaire (1) comprenant : un corps de module de cellule solaire (2) défini en tant qu'une paire de substrats prenant en sandwich au moins une cellule de production d'énergie, ou configuré comme une cellule solaire à colorant ; et une couche d'impression (3) qui est formée plus près d'un côté de surface de réception de lumière que du corps de module de cellule solaire (2), par impression avec une transparence spécifique dans une région spécifique, dans lequel

un côté de surface arrière du module de cellule solaire est visible depuis le côté de surface de réception de lumière dans au moins une partie de la région spécifique, et
la transparence spécifique est réglée de sorte qu'une condition A est satisfaite, la condition A étant qu'un rapport intégral de sensibilité spectrale A défini par la formule (1), présentée ci-dessous, n'est pas inférieur à une valeur spécifique A* que prend le rapport intégral de sensibilité spectrale A lorsque l'impression est réalisée avec une transparence entraînant un rapport de courant de court-circuit de 0,6,
[numérique 1]

$$A = \frac{\int_{360}^{830} (f(\lambda)) d\lambda}{\int_{360}^{830} (f_{SC}(\lambda)) d\lambda} \quad \text{... Formule (1)}$$

où $\lambda$ est la longueur d'onde, en unités de nm,

f($\lambda$) est l'efficacité quantique, IPCE, en unités de %, dans le cas où la couche d'impression est formée, et

$f_{SC}(\lambda)$ est l'efficacité quantique, IPCE, en unités de %, dans le cas où la couche d'impression n'est pas formée.

2. Module de cellule solaire (1) comprenant : un corps de module de cellule solaire (2) défini en tant qu'une paire de substrats prenant en sandwich au moins une cellule de production d'énergie, ou configuré comme une cellule solaire à colorant ; et une couche d'impression (3) qui est formée plus près d'un côté de surface de réception de lumière que du corps de module de cellule solaire (2) par impression en couleur, monochrome rouge, monochrome verte ou monochrome bleue avec une transparence spécifique dans une région spécifique,

dans lequel

un côté de surface arrière du module de cellule solaire est visible depuis le côté de surface de réception de lumière dans au moins une partie de la région spécifique, et

la transparence spécifique est réglée de sorte qu'une condition B est satisfaite, la condition B étant que :

un rapport intégral de sensibilité spectrale $A_K$ défini par la formule (2), présentée ci-dessous, est supérieur ou égal à 0,50 dans le cas où la couche d'impression est en couleur;

un rapport intégral de sensibilité spectrale $A_R$ défini par la formule (3), présentée ci-dessous, est supérieur ou égal à 0,47 dans le cas où la couche d'impression est monochrome rouge ;

un rapport intégral de sensibilité spectrale $A_G$ défini par la formule (4), présentée ci-dessous, est supérieur ou égal à 0,60 dans le cas où la couche d'impression est monochrome verte ; et

un rapport intégral de sensibilité spectrale $A_B$ défini par la formule (5), présentée ci-dessous, est supérieur ou égal à 0,63 dans le cas où la couche d'impression est monochrome bleue,

[numérique 2]

$$A_K = \frac{\int_{400}^{700}(f_K(\lambda))d\lambda}{\int_{400}^{700}(f_{SC}(\lambda))d\lambda} \quad \text{... Formule (2)}$$

[numérique 3]

$$A_R = \frac{\int_{400}^{700}(f_R(\lambda))d\lambda}{\int_{400}^{700}(f_{SC}(\lambda))d\lambda} \quad \text{... Formule (3)}$$

[numérique 4]

$$A_G = \frac{\int_{400}^{700}(f_G(\lambda))d\lambda}{\int_{400}^{700}(f_{SC}(\lambda))d\lambda} \quad \text{... Formule (4)}$$

[numérique 5]

$$A_B = \frac{\int_{400}^{700}(f_B(\lambda))d\lambda}{\int_{400}^{700}(f_{SC}(\lambda))d\lambda} \quad \text{... Formule (5)}$$

où $f_K(\lambda)$ est l'efficacité quantique, IPCE, en unités de %, dans le cas où la couche d'impression est formée par une impression noire sur toute la surface,

$f_R(\lambda)$ est l'efficacité quantique, IPCE, en unités de %, dans le cas où la couche d'impression est formée par une impression monochrome rouge sur toute la surface,

$f_G(\lambda)$ est l'efficacité quantique, IPCE, en unités de %, dans le cas où la couche d'impression est formée par une impression monochrome verte sur toute la surface, et

$f_B(\lambda)$ est l'efficacité quantique, IPCE, en unités de %, dans le cas où la couche d'impression est formée par une impression monochrome bleue sur toute la surface.

3. Module de cellule solaire (1) comprenant : un corps de module de cellule solaire (2) défini en tant qu'une paire de substrats prenant en sandwich au moins une cellule de production d'énergie ou configuré comme une cellule solaire à colorant ; et une couche d'impression (3) qui est formée plus près d'un côté de surface de réception de lumière que du corps de module de cellule solaire (2), par une impression monochrome rouge, monochrome verte ou monochrome bleue avec une transparence spécifique dans une région spécifique, dans lequel

un côté de surface arrière du module de cellule solaire est visible depuis le côté de surface de réception de lumière dans au moins une partie de la région spécifique, et
la transparence spécifique est réglée de sorte qu'une condition C est satisfaite, la condition C étant que :

un rapport intégral de sensibilité spectrale à une longueur d'onde désignée rouge $B_R$, défini par la formule (6), présentée ci-dessous, est supérieur ou égal à 0,18, un rapport intégral de sensibilité spectrale à une longueur d'onde non désignée rouge $C_R$, défini par la formule (7), présentée ci-dessous, est supérieur ou égal à 0,29, et un rapport de crête de sensibilité spectrale rouge $P_R$, défini par la formule (8), présentée ci-dessous, est supérieur ou égal à 0,70 dans le cas où la couche d'impression est monochrome rouge ;
un rapport intégral de sensibilité spectrale à une longueur d'onde désignée verte $B_G$, défini par la formule (9), présentée ci-dessous, est supérieur ou égal à 0,37, un rapport intégral de sensibilité spectrale à une longueur d'onde non désignée verte $C_G$, défini par la formule (10), présentée ci-dessous, est supérieur ou égal à 0,23, et un rapport de crête de sensibilité spectrale verte $P_G$, défini par la formule (11), présentée ci-dessous, est supérieur ou égal à 0,78 dans le cas où la couche d'impression est monochrome verte ; et
un rapport intégral de sensibilité spectrale à une longueur d'onde désignée bleue $B_B$, défini par la formule (12), présentée ci-dessous, est supérieur ou égal à 0,38, un rapport intégral de sensibilité spectrale à une longueur d'onde non désignée bleue $C_B$, défini par la formule (13), présentée ci-dessous, est supérieur ou égal à 0,25, et un rapport de crête de sensibilité spectrale bleue $P_B$, défini par la formule (14), présentée ci-dessous, est supérieur ou égal à 0,77 dans le cas où la couche d'impression est monochrome bleue,
[numérique 6]

$$B_R = \frac{\int_{560}^{660}(f_R(\lambda))d\lambda}{\int_{400}^{700}(f_{SC}(\lambda))d\lambda} \quad \text{... Formule (6)}$$

[numérique 7]

$$C_R = \frac{\int_{400}^{560}(f_R(\lambda))d\lambda}{\int_{400}^{700}(f_{SC}(\lambda))d\lambda} + \frac{\int_{660}^{700}(f_R(\lambda))d\lambda}{\int_{400}^{700}(f_{SC}(\lambda))d\lambda} \quad \text{... Formule (7)}$$

[numérique 8]

$$P_R = \frac{f_R(\lambda_{RP})}{f_{SC}(\lambda_{RP})} \quad \text{... Formule (8)}$$

[numérique 9]

$$B_G = \frac{\int_{480}^{580}(f_G(\lambda))d\lambda}{\int_{400}^{700}(f_{SC}(\lambda))d\lambda} \quad \text{... Formule (9)}$$

[numérique 10]

$$C_G = \frac{\int_{400}^{480}(f_G(\lambda))d\lambda}{\int_{400}^{700}(f_{SC}(\lambda))d\lambda} + \frac{\int_{580}^{700}(f_G(\lambda))d\lambda}{\int_{400}^{700}(f_{SC}(\lambda))d\lambda}$$ ... Formule (10)

[numérique 11]

$$P_G = \frac{f_G(\lambda_{GP})}{f_{SC}(\lambda_{GP})}$$ ... Formule (11)

[numérique 12]

$$B_B = \frac{\int_{430}^{530}(f_B(\lambda))d\lambda}{\int_{400}^{700}(f_{SC}(\lambda))d\lambda}$$ ... Formule (12)

[numérique 13]

$$C_B = \frac{\int_{400}^{430}(f_B(\lambda))d\lambda}{\int_{400}^{700}(f_{SC}(\lambda))d\lambda} + \frac{\int_{530}^{700}(f_B(\lambda))d\lambda}{\int_{400}^{700}(f_{SC}(\lambda))d\lambda}$$ ... Formule (13)

[numérique 14]

$$P_B = \frac{f_B(\lambda_{BP})}{f_{SC}(\lambda_{BP})}$$ ... Formule (14)

où $\lambda_{RP}$ est $\lambda$ lorsque $f_R(\lambda)$ est à une valeur de crête dans un intervalle de longueur d'onde désignée rouge de 560 nm $\leq \lambda \leq$ 660 nm,
$\lambda_{GP}$ est $\lambda$ lorsque $f_G(\lambda)$ est à une valeur de crête dans un intervalle de longueur d'onde désignée verte de 480 nm $\leq \lambda \leq$ 580 nm, et
$\lambda_{BP}$ est $\lambda$ lorsque $f_B(\lambda)$ est à une valeur de crête dans un intervalle de longueur d'onde désignée bleue de 430 nm $\leq \lambda \leq$ 530 nm.

4. Module de cellule solaire (1) selon l'une quelconque des revendications 1 à 3, dans lequel

le corps de module de cellule solaire (2) comprend une paire de substrats prenant en sandwich au moins une cellule de production d'énergie, et
la couche d'impression est formée sur un substrat situé du côté de surface de réception de lumière.

5. Module de cellule solaire (1) selon l'une quelconque des revendications 1 à 3, dans lequel

le corps de module de cellule solaire (2) comprend une paire de substrats prenant en sandwich au moins une cellule de production d'énergie, et
la couche d'impression est formée sur un film qui est fixé sur un substrat situé du côté de surface de réception de lumière.

6. Module de cellule solaire (1) selon la revendication 5, comprenant en outre une couche adhésive qui fait adhérer le film sur le substrat situé du côté de surface de réception de lumière, dans lequel
la couche adhésive est une feuille adhésive en forme de film qui présente une fonction de filtre ultraviolet bloquant la lumière ultraviolette ayant une longueur d'onde inférieure à 400 nm.

7. Module de cellule solaire (1) selon l'une quelconque des revendications 1 à 6, dans lequel
l'impression est réalisée avec une transparence différente et/ou une couleur différente de celles de la couche d'impression dans une région différente de la région spécifique au niveau d'une surface où la couche d'impression est formée.

8. Module de cellule solaire (1) selon l'une quelconque des revendications 1 à 7, dans lequel le corps de module de cellule solaire (2) est configuré comme une cellule solaire à colorant.

9. Module de cellule solaire (1) comprenant : un corps de module de cellule solaire (2) défini en tant qu'une paire de substrats prenant en sandwich au moins une cellule de production d'énergie, ou configuré comme une cellule solaire à colorant ; et une couche d'impression (3) formée plus loin vers un côté de surface arrière du module de cellule solaire, qui est un côté opposé à un côté de surface de réception de lumière, que le corps de module de cellule solaire, par impression avec une transparence spécifique dans une région spécifique, dans lequel

le côté de surface de réception de lumière est visible depuis le côté de surface arrière dans au moins une partie de la région spécifique, et
la transparence spécifique est réglée de sorte qu'au moins l'une parmi la condition A selon la revendication 1, la condition B selon la revendication 2 et la condition C selon la revendication 3, est satisfaite pour la couche d'impression (3) formée sur le côté de surface arrière.

10. Panneau, comprenant :

le module de cellule solaire (1) selon l'une quelconque des revendications 1 à 9 ; et
une feuille sur laquelle le module de cellule solaire (1) est fixé dans une région partielle, dans lequel
la feuille comprend une couche d'impression qui est formée dans une région différente de la région partielle et dans laquelle une impression chevauchant la couche d'impression du module de cellule solaire est formée.

11. Dispositif de génération de données d'impression (11) qui génère des données d'impression pour imprimer uniquement une partie d'une image spécifique dans le module de cellule solaire (1) selon l'une quelconque des revendications 1 à 9, comprenant une section de traitement de données (13) qui obtient des données d'impression correspondant à ladite une partie de l'image spécifique à partir de données correspondant à l'image spécifique, afin de former la couche d'impression (3).

12. Dispositif de génération de données d'impression (11) qui génère des données d'impression pour imprimer une image spécifique dans le panneau selon la revendication 10, comprenant une section de traitement de données (13) qui obtient des données d'impression correspondant à une partie de l'image spécifique à partir de données correspondant à l'image spécifique afin de former la couche d'impression du module de cellule solaire qui doit afficher uniquement ladite une partie de l'image spécifique et qui obtient des données d'impression correspondant à une autre partie de l'image spécifique à partir de données correspondant à l'image spécifique afin de former la couche d'impression de la feuille qui doit afficher uniquement l'autre partie de l'image spécifique.

FIG. 1

FIG. 2

# FIG. 3

Magnification (×200)

# FIG. 4

R80 (×500)　　　　　　R60 (×500)　　　　　　R40 (×500)

G80 (×500)　　　　　　G60 (×500)　　　　　　G40 (×500)

B80 (×500)　　　　　　B60 (×500)　　　　　　B40 (×500)

K80_RGB (×500)　　　　　　K60_RGB (×500)

**FIG. 5A**

Normalized IV characteristic (R)

Legend: SC (no printing), R90, R80, R60, R40, R20, R0

(Plot: Normalized current vs Voltage [V])

**FIG. 5B**

IPCE (R transparent printing)

Legend: SC (no printing), R90, R80, R60, R40, R20, R0

(Plot: IPCE [%] vs Wavelength [nm])

# FIG. 6A

| SC (no printing) | —————— |
|---|---|
| G90 | – – – – |
| G80 | —··—··— |
| G60 | —·—·—· |
| G40 | —··—··— |
| G20 | ———— |
| G0 | ·········· |

Normalized IV characteristic (G)

# FIG. 6B

| SC (no printing) | —————— |
|---|---|
| G90 | – – – – |
| G80 | —··—··— |
| G60 | —·—·—· |
| G40 | —··—··— |
| G20 | ———— |
| G0 | ·········· |

IPCE (G transparent printing)

## FIG. 7A

Normalized IV characteristic (B)

| | |
|---|---|
| SC (no printing) | —————— |
| B90 | — — — — |
| B80 | —··—··—··— |
| B60 | —·—·—·— |
| B40 | —··—··—·· |
| B20 | ——————— |
| B0 | ············· |

Normalized current vs. Voltage [V]

## FIG. 7B

IPCE (B transparent printing)

| | |
|---|---|
| SC (no printing) | —————— |
| B90 | — — — — |
| B80 | —··—··—··— |
| B60 | —·—·—·— |
| B40 | —··—··—·· |
| B20 | ——————— |
| B0 | ············· |

IPCE [%] vs. Wavelength [nm]

*FIG. 8A*

| SC (no printing) | ——————— |
|---|---|
| K100 | — — — — |
| K80 | —·—··—·— |
| K60 | —··—··—·· |
| K40 | —·—·—·— |
| K20 | – – – – |
| K0 | ············ |

Normalized IV characteristic (K)

*FIG. 8B*

| SC (no printing) | ——————— |
|---|---|
| K100 | — — — — |
| K80 | —·—··—·— |
| K60 | —··—··—·· |
| K40 | —·—·—·— |
| K20 | – – – – |
| K0 | ············ |

IPCE (K transparent printing)

## FIG. 9

Normalized short circuit current vs. transparency

## FIG. 10

Normalized IPCE vs. transparency (R transparent printing)

# FIG. 11

Normalized IPCE vs. transparency (G transparent printing)

# FIG. 12

Normalized IPCE vs. transparency (B transparent printing)

# FIG. 13

IPCE characteristic (R transparent printing with T = 0.5 set)

# FIG. 14

IPCE characteristic (G transparent printing with T = 0.5 set)

# FIG. 15

IPCE characteristic (B transparent printing with T = 0.5 set)

# FIG. 16

IPCE characteristic (K transparent printing with T = 0.58 set)

EP 4 219 177 B1

# FIG. 17

| First masking | First transparent printing | Second masking | Second transparent printing |

4    R   6      3    R      7    R      3    R

LNES

# FIG. 18

EP 4 219 177 B1

*FIG. 19*

# FIG. 20

11

Printing data generation device

Data input section ~12

Data processing section ~13

Data output section ~14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017216766 A

- WO 2017141100 A1